# EUROPEAN PATENT APPLICATION

(11) **EP 4 063 425 A1**
(43) Date of publication of application: **28.09.2022**
(21) Application number: 20889863.5
(22) Date of filing: 22.10.2020
(51) Int. Cl.: C08G 61/12, C08G 73/02, C08L 65/00, C08L 79/02, H05B 33/10, H01L 51/50

(54) **COMPOSITION COMPRISING POLYMER COMPOUND, METHOD FOR PRODUCING POLYMER COMPOUND, AND METHOD FOR PRODUCING LIGHT EMITTING DEVICE USING POLYMER COMPOUND**

(30) Priority: 21.11.2019 JP 2019210429
(71) Applicant: SUMITOMO CHEMICAL COMPANY, LIMITED, Tokyo 103-6020 (JP)
(72) Inventor: TERAI, Hiroki, Osaka-shi, Osaka 554-8558 (JP); SUGA, Kenta, Osaka-shi, Osaka 554-8558 (JP); HAYASHI, Kentaro, Osaka-shi, Osaka 554-8558 (JP)
(74) Representative: J A Kemp LLP
(86) International application number: PCT/JP2020/039658
(87) International publication number: WO 2021/100399

(57) **Abstract**

The present invention provides a composition containing a polymer compound excellent in inkjet dischargeability, a production method of the polymer compound, and a production method of a light emitting device using the polymer compound.
A composition containing
(a) a polymer compound containing a constitutional unit represented by the formula (U-1) and a constitutional unit represented by the formula (U-2), wherein the ratio (Mz/Mw) of the polystyrene-equivalent z-average molecular weight (Mz) to the polystyrene-equivalent weight-average molecular weight (Mw) in the polymer compound is 1 or more and less than 3,
(b) at least one compound selected from the group consisting of a light emitting compound, a charge transporting compound and a charge injection compound, different from the above-described polymer compound, and
(c) a solvent;
and the like. 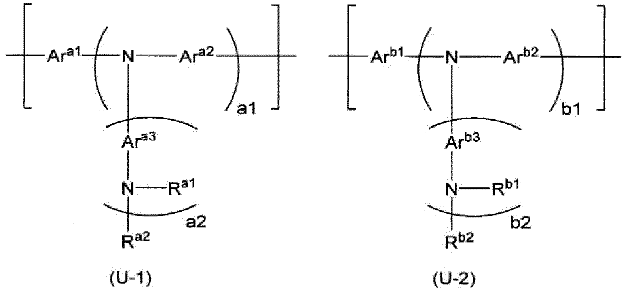 [wherein, Ar^{a1} to Ar^{a3}, Ar^{b1} to Ar^{b3} represent a divalent aromatic hydrocarbon group or a divalent hetero ring group, and the like, and R^{a1}, R^{a2}, R^{b1} and R^{b2} represent an alkyl group, an aryl group or a monovalent hetero ring group, and the like. a1 and b1 represent 0, 1 or 2, and a2 and b2 represent 0 or 1.].

## Description

### Field of the Invention

The present invention relates to a composition containing a polymer compound, a production method of the polymer compound and a production method of a light emitting device using the polymer compound.

### Background Art

Organic electroluminescent devices (hereinafter, referred to also as "organic EL device") have high light emission efficiency and low driving voltage, and thus can be suitably used for applications of displays, and are attracting attention in recent years. This light emitting device has organic layers such as a light emitting layer, a charge transporting layer, and the like.

By using a polymer compound as the material of an organic layer, the organic layer can be formed by an application method typified by an inkjet printing method. A polymer compound used for producing a light emitting device, and its production method have been studied.

Such a polymer compound can be produced by polymerizing prescribed monomer compounds by the Suzuki reaction, the Grignard reaction, the Yamamoto reaction, the Ullmann reaction, the Buchwald-Hartwig reaction, and the like. Further, Patent Documents 1 and 2 describe that a polymer compound is obtained by polymerization-reacting a monomer compound, then, further additionally adding the monomer compound as a solid.

### Prior Art Document

### Patent Document

Patent Document 1: Japanese Translation of PCT International Application Publication (JP-T) No. 2005-511807
Patent Document 2: Japanese Unexamined Patent Application Publication (JP-A) No. 2017-2287

### Summary of the Invention

### Problem to be Solved by the Invention

However, when inkjet printing is performed using a composition containing a polymer compound obtained by conventional production methods described in Patent Documents 1 and 2 was not necessarily excellent in inkjet dischargeability.

Then, the present invention has an object of providing a composition containing a polymer compound excellent in inkjet dischargeability. Further, the present invention has an object of providing a production method of the polymer compound and a production method of a light emitting device using the polymer compound.

### Means for Solving the Problem

The present inventors have intensively studied to solve the above-described problem and resultantly found that in a composition containing a polymer compound obtained by conventional production methods, a polymer component having extremely large molecular weight derived from the polymer compound production method (hereinafter, referred to also as "ultra-high molecular weight component") is contained, which causes discharge failure of inkjet.

Then, the present inventors have found a method capable of significantly suppressing generation of an ultra-high molecular weight component by variously improving the polymer compound production method. Also it has been found that when inkjet printing is performed using a composition containing a polymer compound having small content of an ultra-high molecular weight component, inkjet dischargeability becomes extremely good. Further, the present inventors have found that the parameter (Mz/Mw) derived from the z-average molecular weight (Mz) and the weight-average molecular weight (Mw) of a polymer compound is correlated with the content of an ultra-high molecular weight component in the polymer compound, eventually, closely corelated with the inkjet dischargeability of a composition containing the polymer compound.

Based on such findings, the present inventors have further studied, leading to completion of the present invention.

The present invention provides the following [1] to [7] .

[1] A composition comprising
   (a) a polymer compound containing a constitutional unit represented by the formula (U-1) and a constitutional unit represented by the formula (U-2), wherein the ratio (Mz/Mw) of the polystyrene-equivalent z-average molecular weight (Mz) to the polystyrene-equivalent weight-average molecular weight (Mw) in the polymer compound is 1 or more and less than 3,
   (b) at least one compound selected from the group consisting of a light emitting compound, a charge transporting compound and a charge injection compound, different from the above-described polymer compound, and
   (c) a solvent: 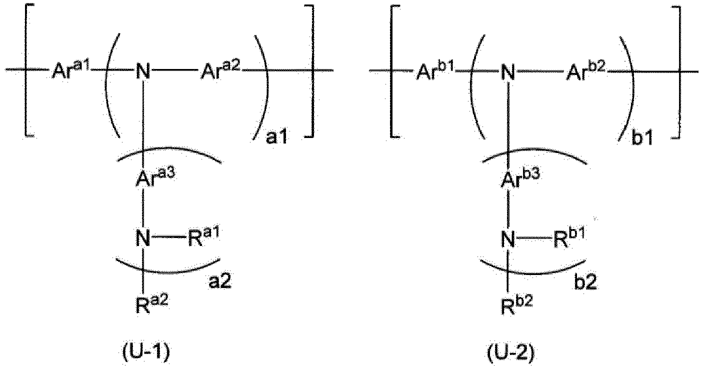 [wherein,
      Ar^{a1}, Ar^{a2}, Ar^{a3}, Ar^{b1}, Ar^{b2} and Ar^{b3} each independently represent a divalent aromatic hydrocarbon group, a divalent hetero ring group, or a divalent group in which two or more groups of divalent aromatic hydrocarbon groups and divalent hetero ring groups are connected directly or via a connecting group, and these groups optionally have a substituent, when a plurality of Ar^{a2}, Ar^{a3}, Ar^{b2} and Ar^{b3} are present, they may be the same or different at each occurrence.
      R^{a1}, R^{a2}, R^{b1} and R^{b2} each independently represent an alkyl group, an aryl group or a monovalent hetero ring group, and these groups optionally have a substituent, when a plurality of R^{a1}, R^{a2}, R^{b1} and R^{b2} are present, they may be the same or different at each occurrence.
      a1 and b1 each independently represent 0, 1 or 2.
      a2 and b2 each independently represent 0 or 1, when a plurality of a2 and b2 are present, they may be the same or different at each occurrence.].
[2] A method of producing a polymer compound containing a constitutional unit represented by the formula (U-1) and a constitutional unit represented by the formula (U-2) in which the ratio (Mz/Mw) of the polystyrene-equivalent z-average molecular weight (Mz) to the polystyrene-equivalent weight-average molecular weight (Mw) in the polymer compound is 1 or more and less than 3, comprising the following steps (I) and (II);
   (I) a first step of polymerization-reacting a compound represented by the formula (M-1) and a compound represented by the formula (M-2), in the presence of a catalyst, a base and a solvent, to obtain a first polymer, and
   (II) a second step of obtaining a second polymer having larger polystyrene-equivalent weight-average molecular weight than that of the above-described first polymer by adopting any of the following steps (A) to (G),
      (A) a step of additionally adding a mixture containing a compound represented by the formula (M-1) or a compound represented by the formula (M-2) and a solvent to the above-described first polymer, and polymerization-reacting them,
      (B) a step of additionally adding a compound represented by the formula (M-1) or a compound represented by the formula (M-2) to the above-described first polymer after lowering the reaction temperature by 10°C or more than in the first step, and thereafter, raising the reaction temperature by 10°C or more and polymerization-reacting them,
      (C) a step of additionally adding a compound represented by the formula (M-1) or a compound represented by the formula (M-2) to the above-described first polymer after lowering the stirring revolution by 20% or more than in the first step, and thereafter, increasing the stirring revolution by 20% or more and polymerization-reacting them,
      (D) a step of additionally adding a mixture containing a compound represented by the formula (M-1) or a compound represented by the formula (M-2) and a solvent to the above-described first polymer after lowering the reaction temperature by 10°C or more than in the first step, and thereafter, raising the reaction temperature by 10°C or more and polymerization-reacting them,
      (E) a step of additionally adding a mixture containing a compound represented by the formula (M-1) or a compound represented by the formula (M-2) and a solvent to the above-described first polymer after lowering the stirring revolution by 20% or more than in the first step, and thereafter, increasing the stirring revolution by 20% or more and polymerization-reacting them,
      (F) a step of additionally adding a compound represented by the formula (M-1) or a compound represented by the formula (M-2) to the above-described first polymer after lowering the reaction temperature by 10°C or more and lowering the stirring revolution by 20% or more than in the first step, and thereafter, raising the reaction temperature by 10°C or more and increasing the stirring revolution by 20% or more and polymerization-reacting them, and
      (G) a step of additionally adding a mixture containing a compound represented by the formula (M-1) or a compound represented by the formula (M-2) and a solvent to the above-described first polymer after lowering the reaction temperature by 10°C or more and lowering the stirring revolution by 20% or more than in the first step, and thereafter, raising the reaction temperature by 10°C or more and increasing the stirring revolution by 20% or more and polymerization-reacting them: 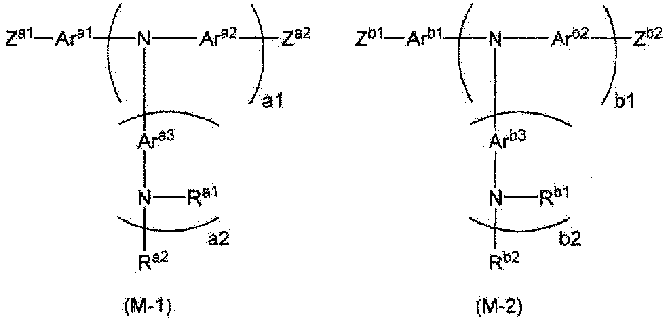 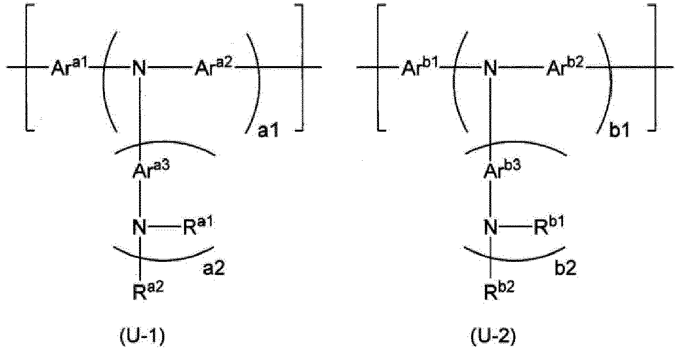 [wherein,
         Z^{a1} and Z^{a2} each independently represent a chlorine atom, a bromine atom, an iodine atom, -O-S(=O)₂R^{Z}, - S(=O)₂Cl, -S(=O)₂R^{Z}, -N₂⁺BF₄⁻, -SR^{Z}, -NR^{Z}₃⁺OTf⁻, -OR^{z}, -O-C(=O)R^{Z} or -C(=O)-OR^{Z}. R^{Z} represents an alkyl group, an aryl group or a monovalent hetero ring group, and these groups optionally have a substituent. When a plurality of R^{Z} are present, they may be the same or different.
         Z^{b1} and Z^{b2} each independently represent a hydrogen atom, -B(OH)₂, a boric acid ester residue or -BF₃T. T represents a lithium atom, a sodium atom, a potassium atom, a rubidium atom or a cesium atom.
         Other marks are as defined above.].
[3] The production method of a polymer compound according to [2], wherein the above-described second step is any of the above-described steps (A) to (D).
[4] A composition comprising
   (a) a polymer compound containing a constitutional unit represented by the formula (U-1) and a constitutional unit represented by the formula (U-3), wherein the ratio (Mz/Mw) of the polystyrene-equivalent z-average molecular weight (Mz) to the polystyrene-equivalent weight-average molecular weight (Mw) in the polymer compound is 1 or more and less than 3,
   (b) at least one compound selected from the group consisting of a light emitting compound, a charge transporting compound and a charge injection compound, different from the above-described polymer compound, and
   (c) a solvent: 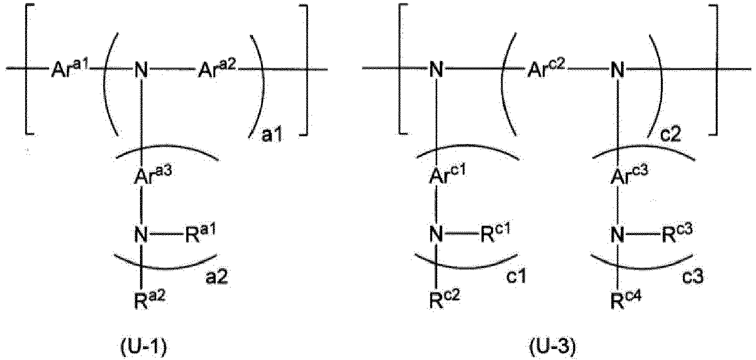 [wherein,
      Ar^{c1}, Ar^{c2} and Ar^{c3} each independently represent a divalent aromatic hydrocarbon group, a divalent hetero ring group, or a divalent group in which two or more groups of divalent aromatic hydrocarbon groups and divalent hetero ring groups are connected directly or via a connecting group, and these groups optionally have a substituent,
      R^{c1}, R^{c2}, R^{c3} and R^{c4} each independently represent an alkyl group, an aryl group or a monovalent hetero ring group, and these groups optionally have a substituent.
      c1, c2 and c3 each independently represent 0 or 1.
      Other marks are as defined above.].
[5] A method of producing a polymer compound containing a constitutional unit represented by the formula (U-1) and a constitutional unit represented by the formula (U-3) in which the ratio (Mz/Mw) of the polystyrene-equivalent z-average molecular weight (Mz) to the polystyrene-equivalent weight-average molecular weight (Mw) in the polymer compound is 1 or more and less than 3, comprising the following steps (I) and (II);
   (I) a first step of polymerization-reacting a compound represented by the formula (M-1) and a compound represented by the formula (M-3), in the presence of a catalyst, a base and a solvent, to obtain a first polymer, and
   (II) a second step of obtaining a second polymer having larger polystyrene-equivalent weight-average molecular weight than that of the above-described first polymer by adopting any of the following steps (A) to (G),
      (A) a step of additionally adding a mixture containing a compound represented by the formula (M-1) or a compound represented by the formula (M-3) and a solvent to the above-described first polymer, and polymerization-reacting them,
      (B) a step of additionally adding a compound represented by the formula (M-1) or a compound represented by the formula (M-3) to the above-described first polymer after lowering the reaction temperature by 10°C or more than in the first step, and thereafter, raising the reaction temperature by 10°C or more and polymerization-reacting them,
      (C) a step of additionally adding a compound represented by the formula (M-1) or a compound represented by the formula (M-3) to the above-described first polymer after lowering the stirring revolution by 20% or more than in the first step, and thereafter, increasing the stirring revolution by 20% or more and polymerization-reacting them,
      (D) a step of additionally adding a mixture containing a compound represented by the formula (M-1) or a compound represented by the formula (M-3) and a solvent to the above-described first polymer after lowering the reaction temperature by 10°C or more than in the first step, and thereafter, raising the reaction temperature by 10°C or more and polymerization-reacting them,
      (E) a step of additionally adding a mixture containing a compound represented by the formula (M-1) or a compound represented by the formula (M-3) and a solvent to the above-described first polymer after lowering the stirring revolution by 20% or more than in the first step, and thereafter, increasing the stirring revolution by 20% or more and polymerization-reacting them,
      (F) a step of additionally adding a compound represented by the formula (M-1) or a compound represented by the formula (M-3) to the above-described first polymer after lowering the reaction temperature by 10°C or more and lowering the stirring revolution by 20% or more than in the first step, and thereafter, raising the reaction temperature by 10°C or more and increasing the stirring revolution by 20% or more and polymerization-reacting them, and
      (G) a step of additionally adding a mixture containing a compound represented by the formula (M-1) or a compound represented by the formula (M-3) and a solvent to the above-described first polymer after lowering the reaction temperature by 10°C or more and lowering the stirring revolution by 20% or more than in the first step, and thereafter, raising the reaction temperature by 10°C or more and increasing the stirring revolution by 20% or more and polymerization-reacting them: 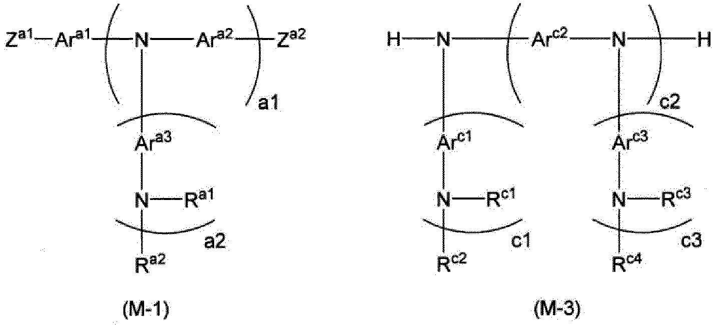 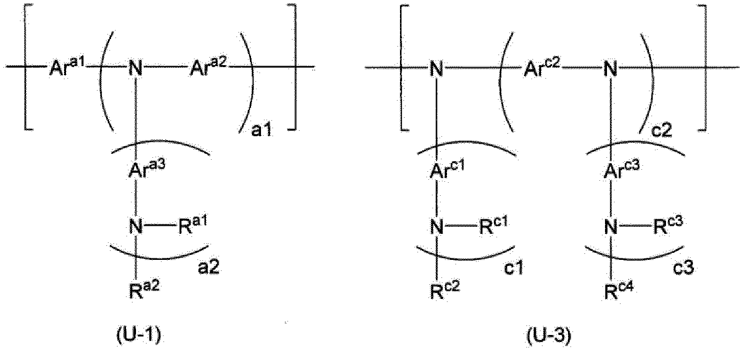 [wherein,
         Z^{a1} and Z^{a2} each independently represent a chlorine atom, a bromine atom, an iodine atom, -O-S(=O)₂R^{Z}, - S(=O)₂Cl , -S(=O)₂R^{Z}, -N₂⁺BF₄⁻, -SR^{Z}, -NR^{Z}₃⁺OTf⁻, -OR^{Z}, -O-C(=O)R^{Z} or -C(=O)-OR^{Z}. R^{Z} represents an alkyl group, an aryl group or a monovalent hetero ring group, and these groups optionally have a substituent. When a plurality of R^{Z} are present, they may be the same or different.
         Other marks are as defined above.].
[6] The method of producing a polymer compound according to [5], wherein the above-described second step is any of the above-described steps (A) to (D).
[7] A method of producing a light emitting device having an anode, a cathode and an organic layer, comprising
   a step of producing a polymer compound by the production method as described in the above-described [2], [3], [5] or [6], and
   a step of forming between an anode and a cathode an organic layer using a composition containing (a) the above-described polymer compound, (b) at least one compound selected from the group consisting of a light emitting compound, a charge transporting compound and a charge injection compound, different from the above-described polymer compound, and (c) a solvent.

### Effect of the Invention

According to the present invention, a composition containing a polymer compound excellent in inkjet dischargeability can be provided. Further, according to the present invention, a method of producing the above-described polymer compound and a method of producing a light emitting device using the above-described polymer compound can be provided.

### Brief Explanation of Drawings

FIG. 1 shows the result of evaluation of dischargeability of an ink composition A conducted in Example 13.
FIG. 2 shows the result of evaluation of dischargeability of an ink composition B conducted in Comparative Example 6.

### Modes for Carrying Out the Invention

Suitable embodiments of the present invention will be explained below.

### 1. Explanation of common terms

Terms commonly used in the present specification have the following meanings unless otherwise stated.

"The hydrogen atom" may be a light hydrogen atom or a deuterated hydrogen atom.

"The alkyl group" means a linear, branched or cyclic alkyl group. The number of carbon atoms of the linear alkyl group is usually 1 to 50, preferably 3 to 30, and more preferably 4 to 20. The number of carbon atoms of the branched and cyclic alkyl groups is usually 3 to 50, preferably 3 to 30, and more preferably 4 to 20. The "alkyl group" includes, for example, a methyl group, an ethyl group, a n-propyl group, an isopropyl group, a n-butyl group, an isobutyl group, a tert-butyl group, a n-pentyl group, an isoamyl group, a 2-ethylbutyl group, a n-hexyl group, a cyclohexyl group, a n-heptyl group, a cyclohexylmethyl group, a cyclohexylethyl group, a n-octyl group, a 2-ethylhexyl group, a 3-n-propylheptyl group, a n-decyl group, a 3,7-dimethyloctyl group, a 2-ethyloctyl group, a 2-n-hexyl-decyl group, a n-dodecyl group, and the like.

"The alkyl group" optionally has 1 to 20 substituents.

"The aryl group" means a monovalent group obtained by removing from an aromatic hydrocarbon one hydrogen atom bonding directly to a carbon atom constituting the ring. The number of carbon atoms of the aromatic hydrocarbon is usually 6 to 60, preferably 6 to 20, and more preferably 6 to 10. The "aryl group" includes, for example, a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group, and the like.

"The aryl group" optionally has 1 to 10 substituents.

"The alkoxy group" means a linear, branched or cyclic alkoxy group. The number of carbon atoms of the linear alkoxy group is usually 1 to 40, and preferably 4 to 10. The number of carbon atoms of the branched and cyclic alkoxy group is usually 3 to 40, and preferably 4 to 10. The "alkoxy group" includes, for example, a methoxy group, an ethoxy group, a n-propyloxy group, an isopropyloxy group, a n-butyloxy group, an isobutyloxy group, a tert-butyloxy group, a n-pentyloxy group, a n-hexyloxy group, a cyclohexyloxy group, a n-heptyloxy group, a n-octyloxy group, a 2-ethylhexyloxy group, a n-nonyloxy group, a n-decyloxy group, a 3,7-dimethyloctyloxy group, a lauryloxy group, and the like.

"The alkoxy group" optionally has 1 to 10 substituents.

"The aryloxy group" means a monovalent group obtained by substituting one hydrogen atom bonding directly to a carbon atom constituting the ring of an aromatic hydrocarbon with an oxygen atom. The number of carbon atoms of "the aryloxy group" is usually 6 to 60, and preferably 7 to 48. The "aryloxy group" includes, for example, a phenoxy group, a 1-naphthyloxy group, a 2-naphthyloxy group, a 1-anthracenyloxy group, a 9-anthracenyloxy group, a 1-pyrenyloxy group, and the like.

"The aryloxy group" optionally has 1 to 10 substituents.

"The substituted amino group" means an amino group having two substituents. The substituent includes, for example, an alkyl group, an aryl group (the aryl group may have an alkyl group), a monovalent hetero ring group, and the like. The "substituted amino group" includes, for example, a dialkylamino group, a diarylamino group, and a di(mono or dialkylaryl)amino group, and specifically includes, for example, a dimethylamino group, a diethylamino group, a diphenylamino group, a bis(4-methylphenyl)amino group, a bis(4-tert-butylphenyl)amino group, a bis(3,5-di-tert-butylphenyl)amino group, and the like.

"The esterified carboxyl group" means a group represented by the formula: -COOR' (R' represents an alkyl group, an aryl group, a monovalent hetero ring group, or the like.). The "esterified carboxyl group" includes, for example, an alkyloxycarbonyl group, and an aryloxycarbonyl group, and specifically includes, for example, a group represented by -CO₂CH₃, a group represented by -CO₂C₂H₅, a group represented by -CO₂C₆H₅, and the like.

"The alkenyl group" may be any of linear, branched or cyclic. The number of carbon atoms of the linear alkenyl group is usually 2 to 30, and preferably 2 to 20. The number of carbon atoms of the branched and cyclic alkenyl group is usually 3 to 30, and preferably 4 to 20. The "alkenyl group" includes, for example, a vinyl group, a 1-propenyl group, a 2-propenyl group, a 2-buten-1-yl group, a 3-buten-1-yl group, a 1-cyclohexenyl group, a 1-norbornyl group, a 2-norbornyl group, and the like.

no

"The alkenyl group" optionally has 1 to 20 substituents.

"The alkynyl group" may be any of linear, branched or cyclic. The number of carbon atoms of the linear alkynyl group is usually 2 to 30, and preferably 2 to 20. The number of carbon atoms of the branched and cyclic alkynyl group is usually 4 to 30, and preferably 4 to 20. The "alkynyl group" includes, for example, an ethynyl group, a 1-propynyl group, a 2-propynyl group, a 2-butyn-1-yl group, a 3-butyn-1-yl group, and the like.

"The alkynyl group" optionally has 1 to 20 substituents.

"The metal complex-containing group" means a group containing a complex formed of a metal atom and ligands coordinating to it. Examples thereof include groups represented by any of the formula (C-1) to formula (C-4). 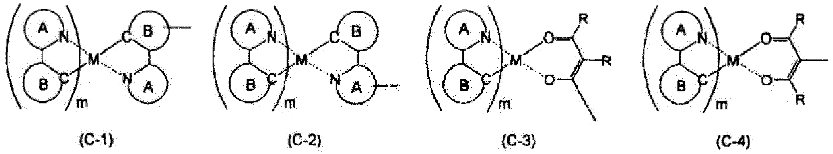 [wherein, M is Ir or Pt. m=2 when M is Ir, while m=1 when M is Pt. Ring A represents a nitrogen atom-containing cyclic structure optionally having a substituent. Ring B represents a carbon atom-containing cyclic structure optionally having a substituent. R represents a hydrogen atom, a fluorine atom, a cyano group, an alkyl group, an aryl group, a monovalent hetero ring group, an alkoxy group, an aryloxy group, a substituted amino group, a carboxyl group, an esterified carboxyl group, an alkenyl group, an alkynyl group, a cross-linkable group or a metal complex-containing group. R optionally has a substituent, when it is a substitutable group. When a plurality of R are present, they may be the same or different. Adjacent groups R may be combined together to form a ring together with carbon atoms to which they are attached.].

Ring A includes, for example, nitrogen-containing aromatic rings (pyridine, and the like). Ring B includes, for example, aromatic rings (benzene, and the like) or heteroaromatic rings (dibenzothiophene, and the like). Ring A and Ring B optionally have a substituent. Ring A and Ring B each optionally have 1 to 4 substituents selected from, for example, a fluorine atom, a cyano group, an alkyl group, an aryl group, a monovalent hetero ring group, an alkoxy group, an aryloxy group, a substituted amino group, a carboxyl group, an esterified carboxyl group, an alkenyl group, an alkynyl group, a cross-linkable group, and the like.

"The divalent aromatic hydrocarbon group" means a divalent group obtained by removing from an aromatic hydrocarbon two hydrogen atoms bonding directly to carbon atoms constituting the ring, and a divalent group obtained by bonding multiple groups (for example, 2 to 5 groups) selected from the group consisting of the divalent groups. The number of carbon atoms of the divalent aromatic hydrocarbon group is usually 6 to 60, preferably 6 to 30, and more preferably 6 to 18. The "divalent aromatic hydrocarbon group" includes, for example, a phenylene group, a naphthalenediyl group, an anthracenediyl group, a phenanthrenediyl group, a dihydrophenanthrenediyl group, a naphthacenediyl group, a fluorenediyl group, a pyrenediyl group, a perylenediyl group, a chrysenediyl group, and the like.

"The divalent aromatic hydrocarbon group" optionally has 1 to 10 substituents. The "divalent aromatic hydrocarbon group optionally having a substituent" includes, for example, groups represented by the formula (A-1) to formula (A-20). 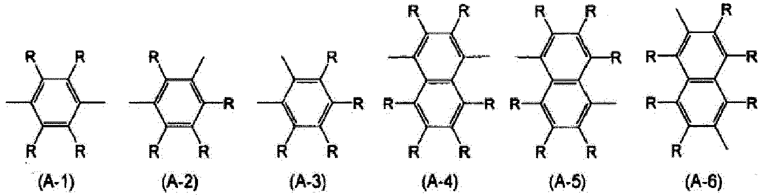 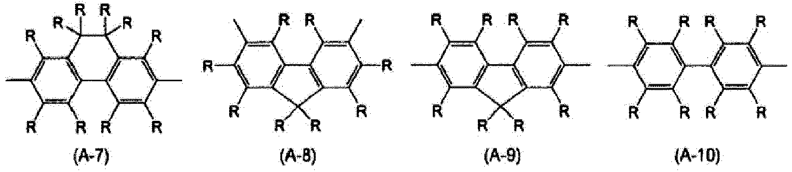 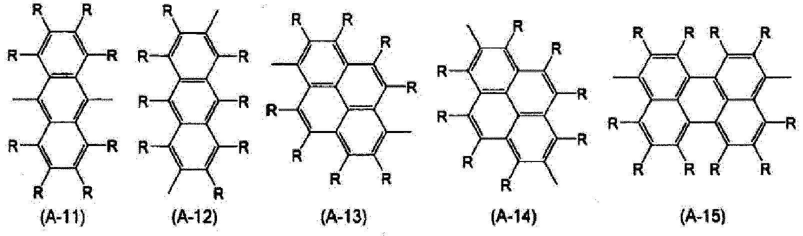 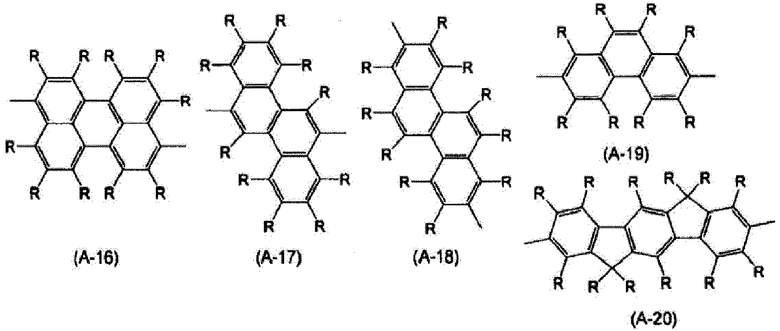 [wherein, R represents the same meaning as described above.].

"The monovalent hetero ring group" means a monovalent group obtained by removing from a heterocyclic compound one hydrogen atom among hydrogen atoms bonding directly to carbon atoms or hetero atoms constituting the ring. Among monovalent hetero ring groups, "a monovalent aromatic hetero ring group" which is a monovalent group obtained by removing from an aromatic heterocyclic compound one hydrogen atom among hydrogen atoms bonding directly to carbon atoms or hetero atoms constituting the ring is preferred. "The monovalent hetero ring group" includes, for example, a thienyl group, a pyrrolyl group, a furyl group, a pyridyl group, a piperidyl group, a quinolyl group, an isoquinolyl group, a pyrimidinyl group, a triazinyl group, and the like.

"The aromatic heterocyclic compound" means any of, for example, a compound in which the hetero ring itself shows aromaticity such as oxadiazole, thiadiazole, thiazole, oxazole, thiophene, pyrrole, phosphole, furan, pyridine, pyrazine, pyrimidine, triazine, pyridazine, quinoline, isoquinoline, carbazole, dibenzosilole, dibenzophosphole, and the like; a compound in which an aromatic ring is condensed to a hetero ring even if the hetero ring itself shows no aromaticity such as phenoxazine, phenothiazine, dibenzoborole, dibenzosilole, benzopyran, and the like; and a compound in which a plurality of these compounds are bonded.

"The monovalent hetero ring group" optionally has 1 to 5 substituents.

"The divalent hetero ring group" means a divalent group obtained by removing from a heterocyclic compound two hydrogen atoms among hydrogen atoms bonding directly to carbon atoms or hetero atoms constituting the ring. Of divalent hetero ring groups, "a divalent aromatic hetero ring group" which is a divalent group obtained by removing from an aromatic heterocyclic compound two hydrogen atoms among hydrogen atoms bonding directly to carbon atoms or hetero atoms constituting the ring is preferred. "The divalent hetero ring group" includes, for example, divalent groups obtained by removing from an aromatic heterocyclic compound such as pyridine, diazabenzene, triazine, azanaphthalene, diazanaphthalene, carbazole, dibenzofuran, dibenzothiophene, dibenzosilole, phenoxazine, phenothiazine, acridine, dihydroacridine, furan, thiophene, azole, diazole, triazole, oxazole, oxadiazole, thiazole, thiadiazole, and the like two hydrogen atoms among hydrogen atoms bonding directly to carbon atoms or hetero atoms constituting the ring, and divalent groups in which a plurality of groups (for example, 2 to 4 groups) selected from the group consisting of the above-mentioned divalent groups are bonded.

"The divalent hetero ring group" optionally has 1 to 5 substituents. The "divalent hetero ring group optionally having a substituent" is preferably a group represented by the formula (A-21) to formula (A-45). 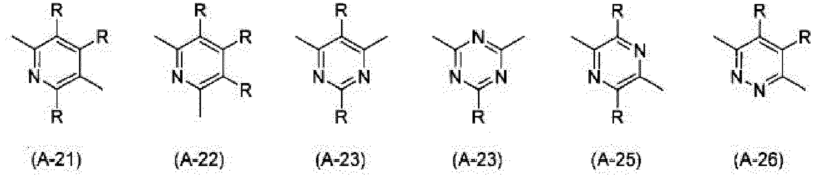 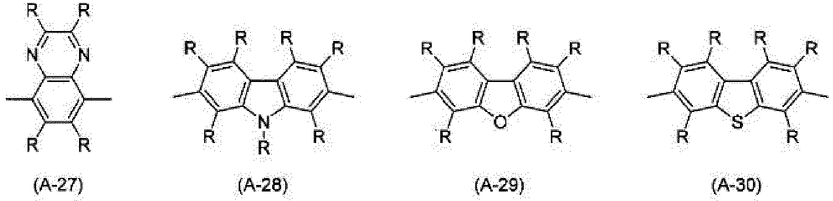 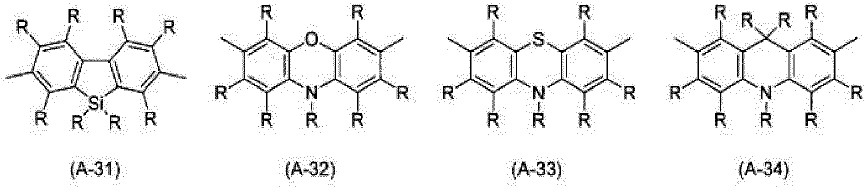 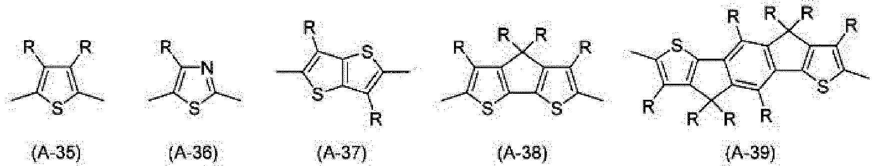 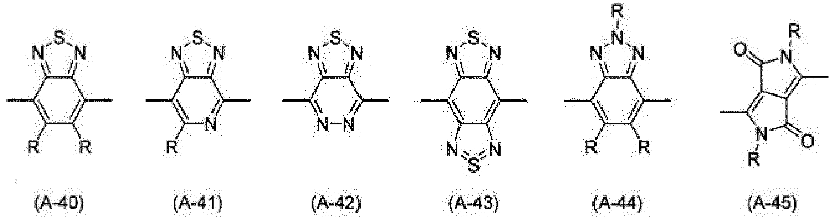 [wherein, R represents the same meaning as described above.].

"The divalent group in which two or more of divalent aromatic hydrocarbon groups and divalent hetero ring groups are connected directly or via a connecting group" means a divalent group in which one or two or more of the above-described divalent aromatic hydrocarbon group and one or two or more of the above-described divalent hetero ring group are bonded directly or via connecting group arbitrarily. The divalent aromatic hydrocarbon group and the divalent hetero ring group include those mentioned above. The connecting group represents, for example, an alkylene group (alkylene group having 1 to 10 carbon atoms, or the like), -O-, -S-, -(CO)-, or a divalent group in which two or more groups selected from them are bonded. However, -O- moieties, -S- moieties, or -O- and -S- are not mutually bonded directly.

"The divalent group in which two or more of divalent aromatic hydrocarbon groups and divalent hetero ring groups are connected directly or via a connecting group" optionally has a substituent, and its partial structure divalent aromatic hydrocarbon group optionally has thereon 1 to 10 substituents, and the other partial structure divalent hetero ring group optionally has thereon 1 to 5 substituents.

"The cross-linkable group" is a group capable of generating a new bond by being subjected to heating, ultraviolet ray irradiation, near ultraviolet ray irradiation, visible light irradiation, infrared ray irradiation, radical reaction, and the like, and preferably includes cross-linkable groups represented by the formula (XL-1) to formula (XL-21).

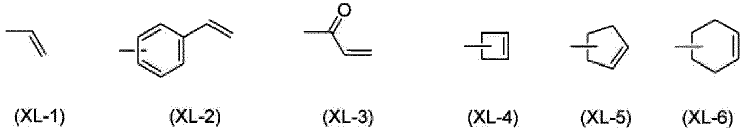

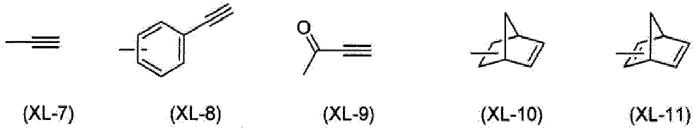

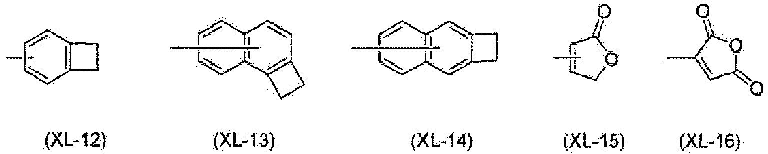

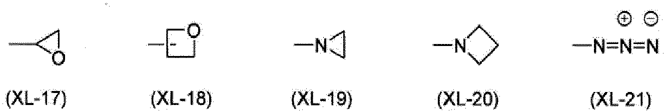

"The cross-linkable group" optionally has 1 to 5 substituents.

"The substituent" represents, for example, a fluorine atom, a cyano group, an alkyl group, an aryl group, a monovalent hetero ring group, an alkoxy group, an aryloxy group, a substituted amino group, a carboxyl group, an esterified carboxyl group, an alkenyl group, an alkynyl group, or a metal complex-containing group. The substituent may be a cross-linkable group. In the present specification, when it is expressed that a certain group optionally has a substituent, it means that the group may have at least one of the groups listed as the substituent.

"The constitutional unit" means a unit occurring once or more times in a polymer compound. "The constitutional unit" usually occurs twice or more times in a polymer compound, and is in general called "repeating unit".

### 2. Composition

The composition of the present invention contains (a) a polymer compound containing a constitutional unit represented by the formula (U-1) and a constitutional unit represented by the formula (U-2), or a constitutional unit represented by the formula (U-1) and a constitutional unit represented by the formula (U-3), wherein the ratio Mz/Mw of the polystyrene-equivalent z-average molecular weight (Mz) to the polystyrene-equivalent weight-average molecular weight (Mw) in the polymer compound is 1 or more and less than 3, (b) at least one compound selected from the group consisting of a light emitting compound, a charge transporting compound and a charge injection compound, different from the above-described polymer compound, and (c) a solvent (usually, ink solvent).

### Component (a) (polymer compound)

One embodiment of the polymer compound contained in the composition of the present invention is a polymer compound containing a constitutional unit represented by the formula (U-1) and a constitutional unit represented by the formula (U-2).

### [Constitutional unit represented by the formula (U-1) and constitutional unit represented by the formula (U-2)]

Ar^{a1}, Ar^{a2}, Ar^{a3}, Ar^{b1}, Ar^{b2} and Ar^{b3} represent preferably a divalent aromatic hydrocarbon group or a divalent hetero ring group, and more preferably a divalent aromatic hydrocarbon group.
R^{a1}, R^{a2}, R^{b1} and R^{b2} represents preferably an alkyl group or an aryl group, and more preferably an aryl group.
a1 and b1 represent preferably 0 or 1.
a2 and b2 represent preferably 0.
When either a1 or b1 is 0, the other is preferably 1 or 2.

The constitutional unit represented by the formula (U-1) includes, for example, constitutional units represented by the formula (V-1) to formula (V-11), and the formula (W-1) to formula (W-7), and constitutional units represented by the formula (V-1) to formula (V-3), the formula (V-6), the formula (V-11), and the formula (W-1) to formula (W-5) are preferred, and constitutional units represented by the formula (V-1), the formula (V-6), and the formula (W-1) to formula (W-3) are more preferred.

The constitutional unit represented by the formula (U-2) includes, for example, constitutional units represented by the formula (V-1) to formula (V-11), and the formula (W-1) to formula (W-7), and constitutional units represented by the formula (V-1) to formula (V-3), the formula (V-6), the formula (V-11), and the formula (W-1) to formula (W-5) are more preferred, and constitutional units represented by the formula (V-1), the formula (V-6), and the formula (W-1) to formula (W-3) are more preferred. 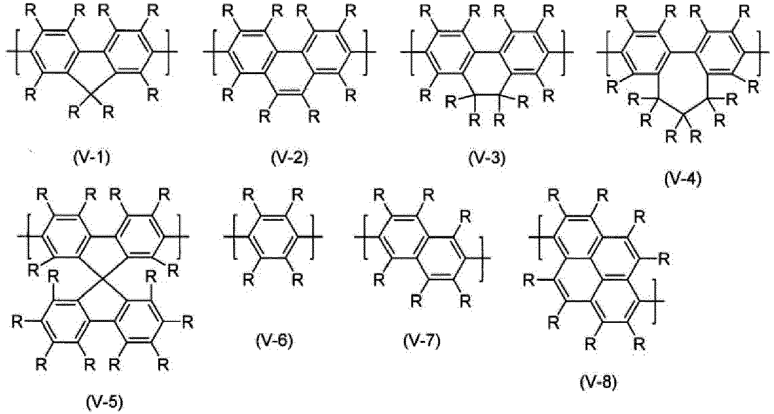 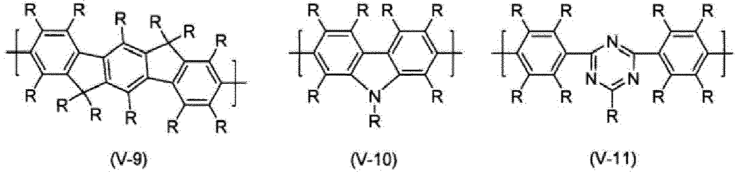 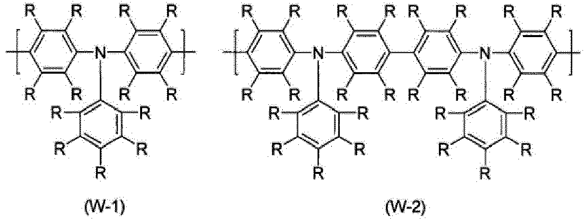 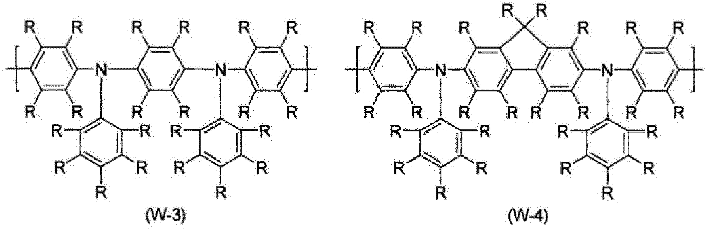 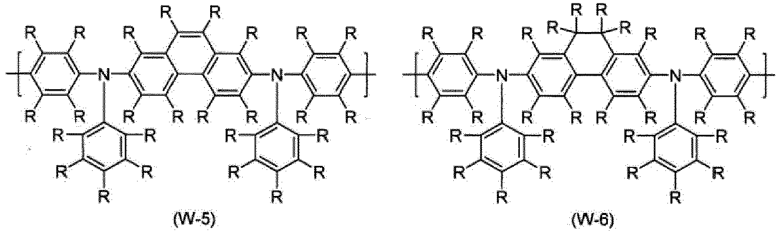 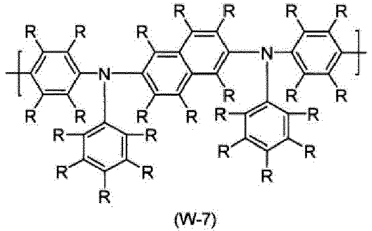 [wherein, R represents the same meaning as described above.].

In the above-described polymer compound, the amount of the constitutional unit represented by the formula (U-1) is usually 1% by mol or more and 99% by mol or less, preferably 20% by mol or more and 80% by mol or less, and more preferably 40% by mol or more and 60% by mol or less, with respect to the total amount of constitutional units contained in a polymer compound.

The constitutional unit represented by the formula (U-1) may be contained only singly or in combination of two or more in a polymer compound.

In the above-described polymer compound, the amount of the constitutional unit represented by the formula (U-2) is usually 1% by mol or more and 99% by mol or less, preferably 20% by mol or more and 80% by mol or less, and more preferably 40% by mol or more and 60% by mol or less, with respect to the total amount of constitutional units contained in a polymer compound.

The constitutional unit represented by the formula (U-2) may be contained only singly or in combination of two or more in a polymer compound.

### [Other constitutional unit]

The above-described polymer compound may contain "other constitutional unit" than the constitutional unit represented by the formula (U-1) and the constitutional unit represented by the formula (U-2).

"The other constitutional unit" includes, for example, constitutional units composed of two or more divalent aromatic hydrocarbon groups, constitutional units composed of two or more divalent hetero ring groups, or constitutional units composed of divalent groups in which divalent groups in which a divalent aromatic hydrocarbon group and a divalent hetero ring group are bonded directly are bonded via at least one group selected from the group consisting of an alkylene group (for example, a group represented by -(CR₂)- (wherein, R represents the same meaning as described above.)), a group represented by -O-, a group represented by -S-, a group represented by -SiR₂-(wherein, R represents the same meaning as described above.), and a group represented by -(CO)-.

"The other constitutional unit" includes, for example, constitutional units represented by the formula (Y-1) to formula (Y-8), and constitutional units represented by the formula (Y-1) to formula (Y-3), and the formula (Y-5) to formula (Y-7) are preferred, and constitutional units represented by the formula (Y-1) to formula (Y-3) are more preferred. 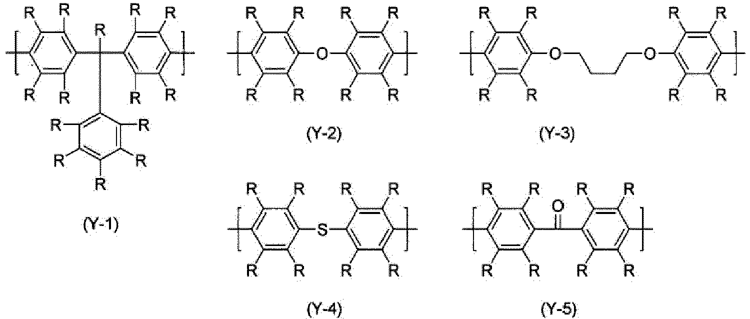 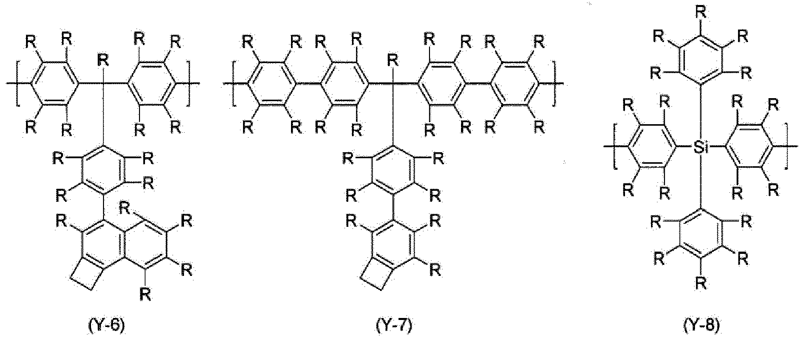 [wherein, R represents the same meaning as described above.].

When the above-described polymer compound contains "other constitutional unit", the amount of "the other constitutional unit" is preferably 1 to 80% by mol, more preferably 1 to 60% by mol, and further preferably 1 to 40% by mol, with respect to the total amount of constitutional units contained in a polymer compound.

"The other constitutional unit" may be contained only singly or in combination of two or more in a polymer compound.

The above-described polymer compound has molecular weight distribution, and the polystyrene-equivalent weight-average molecular weight (Mw) thereof is preferably in the range of 1×10³ to 1×10⁸, more preferably in the range of 1×10⁴ to 1×106, and further preferably in the range of 3×10⁴ to 5×10⁵.

In the above-described polymer compound, the ratio Mz/Mw of the polystyrene-equivalent z-average molecular weight (Mz) to the polystyrene-equivalent weight-average molecular weight (Mw) is 1 or more and less than 3. Mz/Mw is preferably 1.2 or more, more preferably 1.4 or more, and further preferably 1.6 or more, since dischargeability when inkjet-discharging a composition containing the above-described polymer compound is excellent. On the other hand, Mz/Mw is preferably 2.8 or less, more preferably 2.6 or less, and further preferably 2.4 or less. The above-described upper limit and lower limit can be combined arbitrarily.

The above-described polymer compound may be any of a block copolymer, a random copolymer, an alternative copolymer, and a graft copolymer, or may be in other form, and is preferably a copolymer obtained by copolymerizing several kinds of raw material monomers.

One embodiment of the polymer compound contained in the composition of the present invention is a polymer compound containing a constitutional unit represented by the formula (U-1) and a constitutional unit represented by the formula (U-3).

### [Constitutional unit represented by the formula (U-1) and constitutional unit represented by the formula (U-3)]

Ar^{a1}, Ar^{a2}, Ar^{a3}, Ar^{c1}, Ar^{c2} and Ar^{c3} represent preferably a divalent aromatic hydrocarbon group or a divalent hetero ring group, and more preferably a divalent aromatic hydrocarbon group.

R^{a1}, R^{a2}, R^{c1}, R^{c2}, R^{c3} and R^{c4} represent preferably an alkyl group or an aryl group, and more preferably an aryl group.

al, c1, c2 and c3 represent preferably 0.

When either a1 or c2 is 0, the other is preferably 1.

The constitutional unit represented by the formula (U-1) includes, for example, constitutional units represented by the formula (V-1) to formula (V-11), and the formula (W-1) to formula (W-7), and constitutional units represented by the formula (V-1) to formula (V-3), the formula (V-6), the formula (V-11), and the formula (W-1) to formula (W-5) are preferred, and constitutional units represented by the formula (V-1), the formula (V-6), and the formula (W-1) to formula (W-3) are more preferred.

The constitutional unit represented by the formula (U-3) includes, for example, constitutional units represented by the formula (X-1) to formula (X-8), and constitutional units represented by the formula (X-1) to formula (X-6) are preferred, and constitutional units represented by the formula (X-1) to formula (X-3) are more preferred. 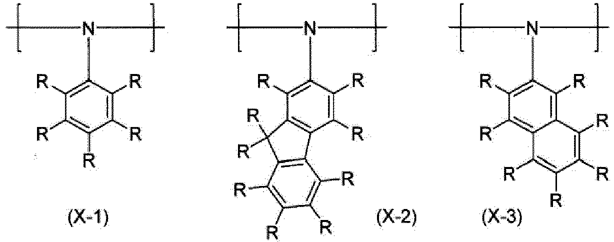 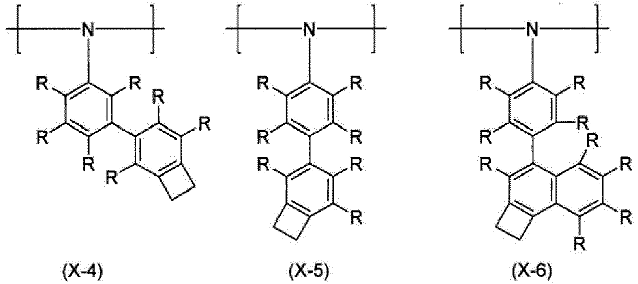 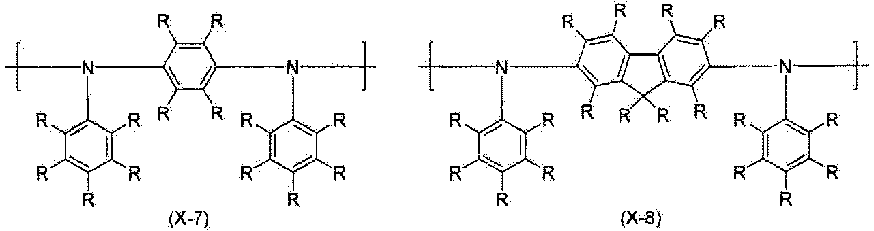 [wherein, R represents the same meaning as described above.].

In the above-described polymer compound, the amount of the constitutional unit represented by the formula (U-1) is usually 1% by mol or more and 99% by mol or less, preferably 20% by mol or more and 80% by mol or less, and more preferably 40% by mol or more and 60% by mol or less, with respect to the total amount of constitutional units contained in a polymer compound.

The constitutional unit represented by the formula (U-1) may be contained only singly or in combination of two or more in a polymer compound.

In the above-described polymer compound, the amount of the constitutional unit represented by the formula (U-3) is usually 1% by mol or more and 99% by mol or less, preferably 20% by mol or more and 80% by mol or less, and more preferably 40% by mol or more and 60% by mol or less, with respect to the total amount of constitutional units contained in a polymer compound.

The constitutional unit represented by the formula (U-3) may be contained only singly or in combination of two or more in a polymer compound.

### [Other constitutional unit]

The above-described polymer compound may contain "other constitutional unit" than the constitutional unit represented by the formula (U-1) and the constitutional unit represented by the formula (U-3).

"The other constitutional unit" includes, for example, constitutional units composed of two or more divalent aromatic hydrocarbon groups, constitutional units composed of two or more divalent hetero ring groups, or constitutional units composed of divalent groups in which divalent groups in which a divalent aromatic hydrocarbon group and a divalent hetero ring group are bonded directly are bonded via at least one group selected from the group consisting of an alkylene group (for example, a group represented by -(CR₂)- (wherein, R represents the same meaning as described above.)), a group represented by -O-, a group represented by -S-, a group represented by -SiR₂-(wherein, R represents the same meaning as described above.), and a group represented by -(CO)-.

"The other constitutional unit" includes, for example, constitutional units represented by the formula (Y-1) to formula (Y-8), and constitutional units represented by the formula (Y-1) to formula (Y-3), and the formula (Y-5) to formula (Y-7) are preferred, and constitutional units represented by the formula (Y-1) to formula (Y-3) are more preferred.

When the above-described polymer compound contains "other constitutional unit", the amount of "the other constitutional unit" is preferably 1 to 80% by mol, more preferably 1 to 60% by mol, and further preferably 1 to 40% by mol, with respect to the total amount of constitutional units contained in a polymer compound.

"The other constitutional unit" may be contained only singly or in combination of two or more in a polymer compound.

The above-described polymer compound has molecular weight distribution, and the polystyrene-equivalent weight-average molecular weight (Mw) thereof is preferably in the range of 1×10³ to 1×10⁸, more preferably in the range of 1×10⁴ to 1×10⁶, and further preferably in the range of 3×10⁴ to 5×10⁵.

In the above-described polymer compound, the ratio Mz/Mw of the polystyrene-equivalent z-average molecular weight (Mz) to the polystyrene-equivalent weight-average molecular weight (Mw) is 1 or more and less than 3. Mz/Mw is preferably 1.2 or more, more preferably 1.4 or more, and further preferably 1.6 or more, since dischargeability when inkjet-discharging a composition containing the above-described polymer compound is excellent. On the other hand, Mz/Mw is preferably 2.8 or less, more preferably 2.6 or less, and further preferably 2.4 or less. The above-described upper limit and lower limit can be combined arbitrarily.

The above-described polymer compound may be any of a block copolymer, a random copolymer, an alternative copolymer, and a graft copolymer, or may be in other form, and is preferably a copolymer obtained by copolymerizing several kinds of raw material monomers.

### Component (b)

At least one compound selected from the group consisting of a light emitting compound, a charge transporting compound and a charge injection compound, different from the above-described polymer compound (component (b)) can be appropriately selected depending on the properties of an organic layer of a light emitting device.

### [Light emitting compound]

The light emitting compound includes, for example, naphthalene and derivatives thereof, anthracene and derivatives thereof, perylene and derivatives thereof, and triplet light emitting complexes having iridium, platinum or europium as the central metal.

In the composition, the content of the light emitting compound is usually 1 to 1000 parts by mass, when the amount of the polymer compound is taken as 100 parts by mass.

The light emitting compound may be used singly or in combination of two or more.

### [Charge transporting compound]

The charge transporting compound includes, for example, aromatic amine compounds such as triphenylamine and derivatives thereof, N,N'-di-1-naphthyl-N,N'-diphenylbenzidine (a-NPD), N,N'-diphenyl-N,N'-di(m-tolyl)benzidine (TPD), and the like, metal complexes having 8-hydroxyquinoline as a ligand; oxadiazole, anthraquinodimethane, benzoquinone, naphthoquinone, anthraquinone, tetracyanoanthraquinodimethane, fluorenone, diphenyldicyanoethylene and diphenoquinone, and derivatives thereof.

In the composition, the content of the charge transporting compound is usually 1 to 1000 parts by mass, when the amount of the polymer compound is taken as 100 parts by mass.

The charge transporting compound may be used singly or in combination of two or more.

### [Charge injection compound]

The charge injection compound includes, for example, metal phthalocyanines such as copper phthalocyanine, and the like; carbon; oxides of metals such as molybdenum, tungsten, and the like; metal fluorides such as lithium fluoride, sodium fluoride, cesium fluoride, potassium fluoride, and the like.

In the composition, the content of the charge injection compound is usually 1 to 1000 parts by mass, when the amount of the polymer compound is taken as 100 parts by mass.

The charge injection compound may be used singly or in combination of two or more.

### Component (c) (ink solvent)

The ink solvent is preferably a solvent capable of dissolving or uniformly dispersing the above-described polymer compound, and at least one compound selected from the group consisting of a light emitting compound, a charge transporting compound and a charge injection compound. The ink solvent includes, for example, chlorinated hydrocarbon solvents such as 1,2-dichloroethane, 1,1,2-trichloroethane, chlorobenzene, o-dichlorobenzene, and the like; ether solvents such as tetrahydrofuran, dioxane, anisole, dimethoxybenzene, 4-methylanisole, and the like; aromatic hydrocarbon solvents such as toluene, xylene, mesitylene, ethylbenzene, n-hexylbenzene, decylbenzene, cyclohexylbenzene, and the like; aliphatic hydrocarbon solvents such as cyclohexane, methylcyclohexane, n-pentane, n-hexane, n-heptane, n-octane, n-nonane, n-decane, n-dodecane, bicyclohexyl, and the like; ketone solvents such as acetone, methyl ethyl ketone, cyclohexanone, acetophenone, and the like; ester solvents such as ethyl acetate, butyl acetate, ethylcellosolve acetate, methyl benzoate, phenyl acetate, and the like; polyhydric alcohol solvents such as ethylene glycol, glycerin, 1,2-hexanediol, and the like; alcohol solvents such as methanol, ethanol, isopropyl alcohol, cyclohexanol, and the like; sulfoxide solvents such as dimethyl sulfoxide, and the like; amide solvents such as N-methyl-2-pyrrolidone, N,N-dimethylformamide, and the like. The solvent may be used singly or in combination of two or more.

The ink solvent is preferably an ether solvent, an aromatic hydrocarbon solvent or an aliphatic hydrocarbon solvent, and more preferably an ether solvent or an aromatic hydrocarbon solvent.

In the composition, the content of the ink solvent is usually 1000 to 100000 parts by mass, when the sum of the above-described polymer compound, and at least one compound selected from the group consisting of a light emitting compound, a charge transporting compound and a charge injection compound is taken as 100 parts by mass.

The ink solvent may be used singly or in combination of two or more.

### 3. Production method of polymer compound

Next, the method of producing a polymer compound of the present embodiment will be described.

### 3.1 Production method of polymer compound containing constitutional unit represented by the formula (U-1) and the formula (U-2)

In the production method of the present invention, a polymer compound containing a constitutional unit represented by the formula (U-1) and a constitutional unit represented by the formula (U-2) in which Mz/Mw is 1 or more and less than 3 can be obtained.

Typically mentioned is a method of using a compound represented by the formula (M-1) and a compound represented by the formula (M-2) as raw material monomers and polymerizing them by the Suzuki coupling reaction. The production method of the present invention contains a combination of the common first step with a plurality of different second steps.

In the first step and the second step, it is preferable to lower the oxygen concentration in a reaction vessel by purging with an inert gas.

In the first step and the second step, the reaction temperature is usually -100°C or more and 200°C or less, preferably 0°C or more and 150°C or less, and further preferably 60°C or more and 120°C or less.

In the first step and the second step, the reaction time is usually 0.1 hours or more, preferably 0.5 hours or more, and more preferably 1 hour or more.

In the first step and the second step, the stirring method includes methods using, for example, a combination of an electric stirrer and a stirring blade, a combination of an air motor stirrer and a stirring blade, a combination of a magnet type stirrer and a stirring blade, or a combination of a magnet type stirrer and a stirring bar.

In the first step and the second step, the optimum range of the stirring revolution is determined depending on the shape and size of the reaction apparatus, and it is usually 30 rpm or more and 2000 rpm or less, preferably 50 rpm or more and 1500 rpm or less, and further preferably 70 rpm or more and 1000 rpm or less.

### (I) First step

The first step is a step of polymerization-reacting a compound represented by the formula (M-1) and a compound represented by the formula (M-2), in the presence of a catalyst, a base and a solvent, to obtain a first polymer.

The compound represented by the formula (M-1) and the compound represented by the formula (M-2) each may be used singly or in combination of two or more.

The catalyst includes a nickel phosphine complex, a combination of a nickel compound with a phosphine compound, a palladium phosphine complex, and a combination of a palladium compound with a phosphine compound, and the like.

The nickel phosphine complex includes dichlorobis(triphenylphosphine)nickel(II), dichlorobis(tricyclohexylphosphine)nickel(II), and the like.

The combination of a nickel compound with a phosphine compound includes a combination of a nickel compound such as bis(cyclooctadiene)nickel (0), nickel(II) chloride, and the like with a phosphine compound such as triphenylphosphine, tricyclohexylphosphine, 1,1'-bis(diphenylphosphino)ferrocene, and the like.

The palladium phosphine complex includes triarylphosphinepalladium complexes such as tetrakis(triphenylphosphine)palladium(0), dichlorobis(triphenylphosphine)palladium(II), dichlorobis(tri-o-tolylphosphine)palladium(II), dichlorobis(tri-o-methoxyphenylphosphine)palladium(II), dichloro[l,l'-bis(diphenylphosphino)ferrocene]palladium(II), and the like; alkyldiarylphosphinepalladium complexes such as dichlorobis(methyldiphenylphosphine)palladium(II), and the like; dialkylarylphosphinepalladium complexes such as dichlorobis(2-dicyclohexylphosphino-2' ,6'-dimethoxy-1,1'-biphenyl)palladium(II), dichloro[di-tert-butyl(p-dimethylaminophenyl)]palladium(II), (2-dicyclohexylphosphino-2' ,4' ,6' ,triisopropyl-1,1'-biphenyl)[2-(2'-amino-1,1'-biphenyl)palladium(II) methanesulfonate, dichlorobis(dicyclopentyl-o-methoxyphenylphosphine)palladium(II), and the like; trialkylphosphinepalladium complexes such as bis(tri-tert-butylphosphine)palladium(0), dichlorobis(tricyclohexylphosphine)palladium(II), and the like; etc.

The combination of a palladium compound with a phosphine compound includes combinations of palladium compounds such as tris(dibenzylideneacetone)dipalladium(0), palladium(II) acetate, palladium(II) chloride, and the like with triarylphosphine compounds such as tri-o-tolylphosphine, tri-o-methoxyphenylphosphine, 1,1'-bis(diphenylphosphino)ferrocene, and the like, alkyldiarylphosphine compounds such as methyldiphenylphosphine, and the like, dialkylarylphosphine compounds such as 2-dicyclohexylphosphino-2',6'-dimethoxy-1,1'-biphenyl, 2-dicyclohexylphosphino-2',4',6',triisopropyl-1,1'-biphenyl, 2-(di-tert-butylphosphino)-1-phenylindole, 2-(di-tert-butylphosphino)-1-phenyl-1H-pyrrole, and the like, trialkylphosphine compounds such as tri-tert-butylphosphine, tri-tert-butylphosphonium tetrafluoroborate, tricyclohexylphosphine, di(1-adamantyl)-n-butylphosphine, and the like; etc.

The catalyst is preferably a palladium complex or a combination of a palladium compound with a phosphine compound, and more preferably a divalent palladium complex or a combination of a divalent palladium compound with a phosphine compound.

Of palladium complexes, preferable are alkyldiarylphosphinepalladium complexes, dialkylarylphosphinepalladium complexes or trialkylphosphinepalladium complexes, and more preferable are dialkylarylphosphinepalladium complexes or trialkylphosphinepalladium complexes.

Of phosphine compounds, preferable are alkyldiarylphosphine compounds, dialkylarylphosphine compounds or trialkylphosphine compounds, and more preferable are dialkylarylphosphine compounds or trialkylphosphine compounds.

The catalyst may be a homogeneous complex catalyst or a heterogeneous complex catalyst, and is preferably a homogeneous complex catalyst.

The use amount of the catalyst is usually 0.00001 mole equivalent or more and 1 mole equivalent or less, in terms of the amount of a metal with respect to the total molar number of raw material monomers.

The base includes, for example, inorganic bases such as sodium carbonate, potassium carbonate, cesium carbonate, potassium fluoride, cesium fluoride, tripotassium phosphate, and the like; and organic bases such as tetrabutylammonium fluoride, tetramethylammonium hydroxide, tetraethylammonium hydroxide, tetrabutylammonium hydroxide, and the like. The base each may be used only singly or in combination of two or more.

The use amount of the base is usually 4 mole equivalent or more and 100 mole equivalent or less, with respect to the total molar number of raw material monomers.

The solvent includes, for example, chlorinated hydrocarbon solvents such as 1,2-dichloroethane, 1,1,2-trichloroethane, chlorobenzene, o-dichlorobenzene, and the like; ether solvents such as tetrahydrofuran, dioxane, anisole, dimethoxybenzene, 4-methylanisole, and the like; aromatic hydrocarbon solvents such as toluene, xylene, mesitylene, ethylbenzene, n-hexylbenzene, decylbenzene, cyclohexylbenzene, and the like; aliphatic hydrocarbon solvents such as cyclohexane, methylcyclohexane, n-pentane, n-hexane, n-heptane, n-octane, n-nonane, n-decane, n-dodecane, bicyclohexyl, and the like; ketone solvents such as acetone, methyl ethyl ketone, cyclohexanone, acetophenone, and the like; ester solvents such as ethyl acetate, butyl acetate, ethylcellosolve acetate, methyl benzoate, phenyl acetate, and the like; polyhydric alcohol solvents such as ethylene glycol, glycerin, 1,2-hexanediol, and the like; alcohol solvents such as methanol, ethanol, isopropyl alcohol, cyclohexanol, and the like; sulfoxide solvents such as dimethyl sulfoxide, and the like; amide solvents such as N-methyl-2-pyrrolidone, N,N-dimethylformamide, and the like; and water. The solvent may be used only singly or in combination of two or more.

As the solvent, it is preferable to use one or more organic solvents and water together.

The ratio of the total volume of one or more organic solvents to the volume of water is preferably 1/2 or more, more preferably 1 or more, further preferably 2 or more, and particularly preferably 4 or more.

The at least one solvent is preferably a hydrophobic organic solvent, more preferably a chlorinated hydrocarbon solvent, an aromatic hydrocarbon solvent or an aliphatic hydrocarbon solvent, and further preferably an aromatic hydrocarbon solvent.

The use amount of the solvent is usually 10 parts by mass or more and 100000 parts by mass or less, preferably 30 parts by mass or more and 30000 parts by mass or less, and more preferably 100 parts by mass or more and 10000 parts by mass or less, with respect to 100 parts by mass of the sum of raw material monomers.

In the first step, further a phase transfer catalyst may be used. The phase transfer catalyst includes, for example, tetrabutylammonium chloride, tetrabutylammonium bromide, and the like. The phase transfer catalyst each may be used only singly or in combination of two or more.

The use amount of the phase transfer catalyst is usually 0.001 mole equivalent or more and 100 mole equivalent or less, with respect to the total molar number of raw material monomers.

The explanation and the preferable examples of Ar^{a1}, Ar^{a2}, Ar^{a3}, Ar^{b1}, Ar^{b2}, Ar^{b3}, R^{a1}, R^{a2}, R^{b1}, R^{b2}, a1, a2, b1 and b2 in a compound represented by the formula (M-1) and a compound represented by the formula (M-2) are the same as the explanation and the preferable examples for a compound represented by the formula (U-1) and a compound represented by the formula (U-2).

Z^{a1} and Z^{a2} represent preferably a chlorine atom or a bromine atom, and more preferably a bromine atom.

As Z^{b1} and Z^{b2}, boric acid ester residues are preferred, boric acid ester residues represented by the formula (G-1) to formula (G-10) are more preferred, and boric acid ester residues represented by the formula (G-4), and the formula (G-6) to formula (G-10) are further preferred.

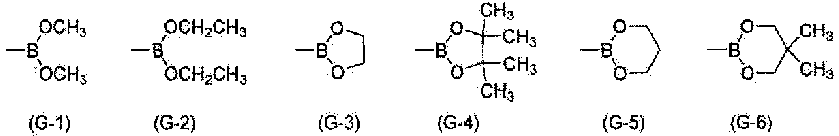

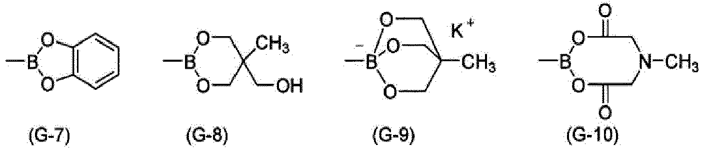

The constitutional unit represented by the formula (M-1) includes, for example, constitutional units derived from compounds represented by the formula (VV-1) to formula (VV-11), and the formula (WW-1) to formula (WW-7), and constitutional units derived from compounds represented by the formula (VV-1) to formula (VV-3), the formula (VV-6), the formula (VV-11), and the formula (WW-1) to formula (WW-5) are preferred, and constitutional units derived from compounds represented by the formula (VV-1), the formula (VV-6), and the formula (WW-1) to formula (WW-3) are more preferred. 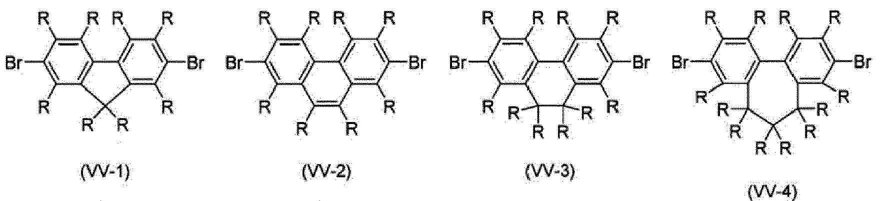 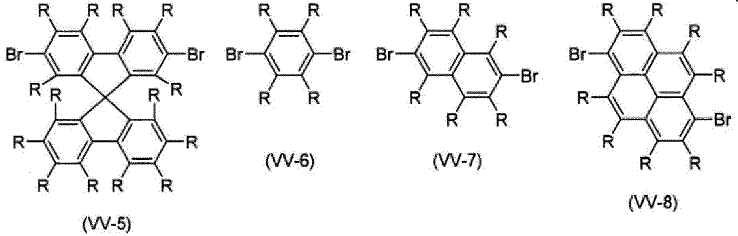 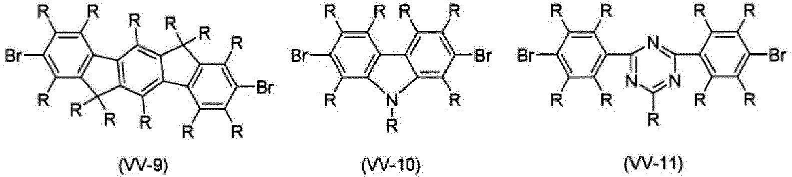 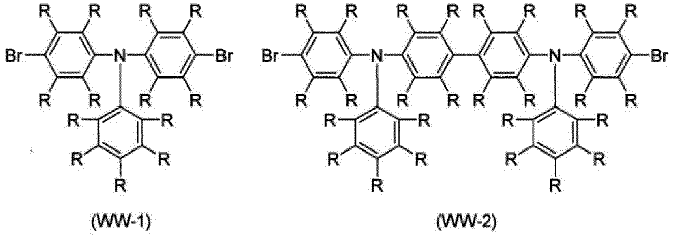 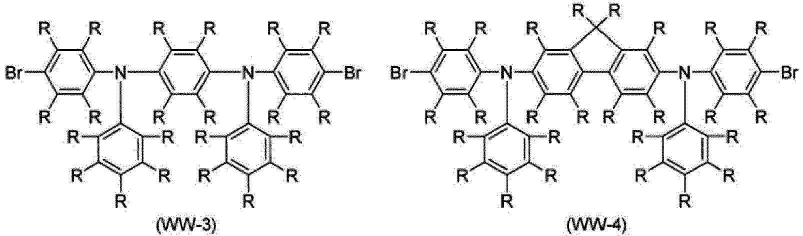 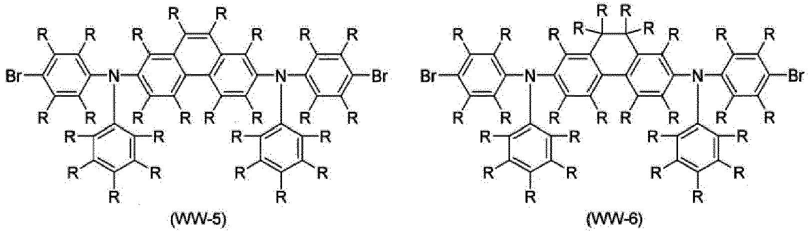 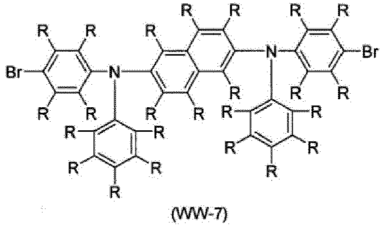 [wherein, R represents the same meaning as described above.].

The constitutional unit represented by the formula (M-2) includes, for example, constitutional units derived from compounds represented by the formula (VVV-1) to formula (VVV-11), and the formula (WWW-1) to formula (WWW-7), and constitutional units derived from compounds represented by the formula (VVV-1) to formula (VVV-3), the formula (VVV-6) , the formula (VVV-11), and the formula (WWW-1) to formula (WWW-5) are preferred, and constitutional units derived from compounds represented by the formula (VVV-1), the formula (VVV-6), and the formula (WWW-1) to formula (WWW-3) are more preferred. 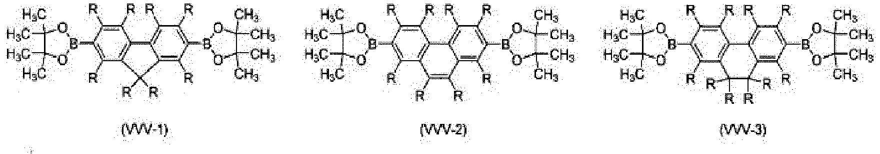 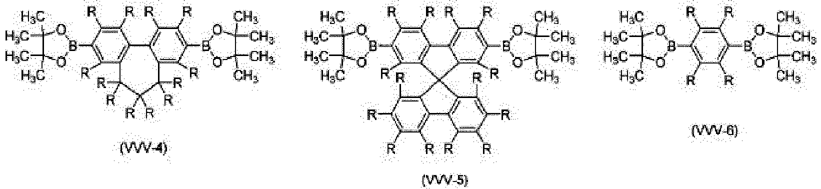 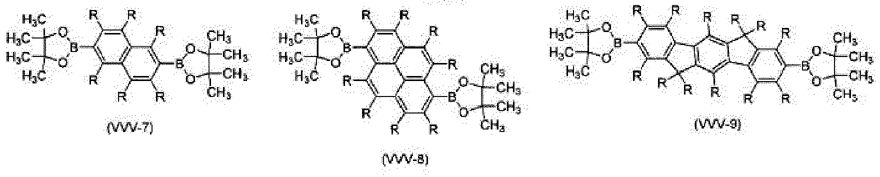 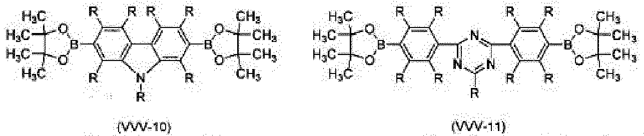 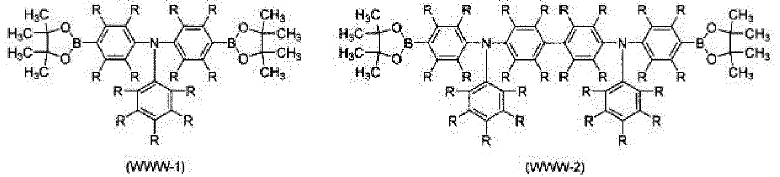 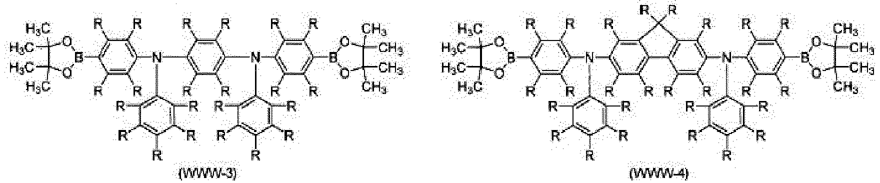 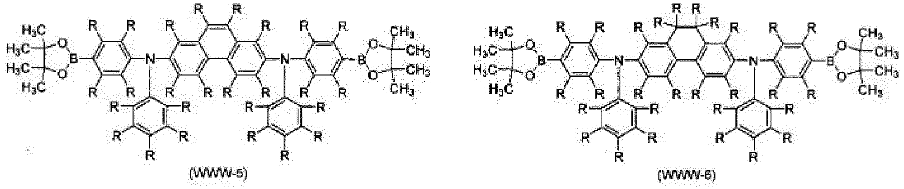 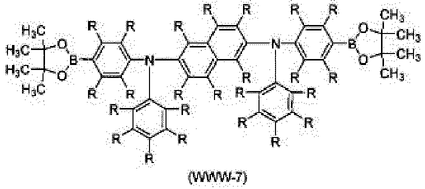 [wherein, R represents the same meaning as described above.].

The first polymer has a polystyrene-equivalent weight-average molecular weight of usually 1×10³ to 1×10⁸, and its Mz/Mw is usually 1 or more and less than 3.

In the first step, "other compounds" than a compound represented by the formula (M-1) and a compound represented by the formula (M-2) may be further polymerization-reacted.

"The other compound" includes, for example, compounds represented by the formula (YY-1) to formula (YY-8), and compounds represented by the formula (YY-1) to formula (YY-3), and the formula (YY-5) to formula (YY-7) are preferred, and compounds represented by the formula (YY-1) to formula (YY-3) are more preferred. 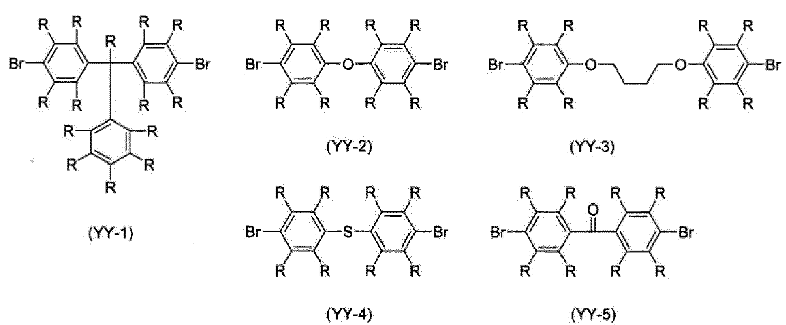 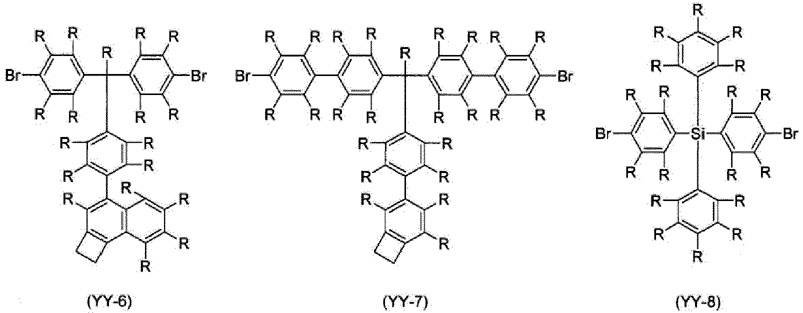 [wherein, R represents the same meaning as described above.].

### (II) Second step

The second step is a step of further additionally adding a compound represented by the formula (M-1) or a compound represented by the formula (M-2) and polymerization-reacting them, to obtain a second polymer having larger polystyrene-equivalent weight-average molecular weight than that of the first polymer, and can be classified into, for example, a second step A to a second step G.

The amount of a compound represented by the formula (M-1) or a compound represented by the formula (M-2) to be additionally added in the second step is preferably 0.01 parts by mass or more and 30 parts by mass or less, more preferably 0.03 parts by mass or more and 10 parts by mass or less, and further preferably 0.1 parts by mass or more and 3 parts by mass or less, with respect to 100 parts by mass of the total amount of a compound represented by the formula (M-1) and a compound represented by the formula (M-2) used in the first step.

The polystyrene-equivalent weight-average molecular weight of the second polymer is larger than that of the first polymer, and is 1×10³ to 1×10⁸, with Mz/Mw being 1 or more and less than 3.

### [Second step A]

The second step A is a step of additionally adding a mixture of a compound represented by the formula (M-1) or a compound represented by the formula (M-2) and a solvent to a reaction liquid containing the above-described first polymer, and polymerization-reacting them, to obtain a second polymer having larger polystyrene-equivalent weight-average molecular weight than that of the above-described first polymer.

The solvent is preferably one capable of dissolving a compound represented by the formula (M-1) or a compound represented by the formula (M-2), and is not particularly restricted. Examples thereof include chlorinated hydrocarbon solvents such as 1,2-dichloroethane, 1,1,2-trichloroethane, chlorobenzene, o-dichlorobenzene, and the like; ether solvents such as tetrahydrofuran, dioxane, anisole, dimethoxybenzene, 4-methylanisole, and the like; aromatic hydrocarbon solvents such as toluene, xylene, mesitylene, ethylbenzene, n-hexylbenzene, decylbenzene, cyclohexylbenzene, and the like; aliphatic hydrocarbon solvents such as cyclohexane, methylcyclohexane, n-pentane, n-hexane, n-heptane, n-octane, n-nonane, n-decane, n-dodecane, bicyclohexyl, and the like; ketone solvents such as acetone, methyl ethyl ketone, cyclohexanone, acetophenone, and the like; ester solvents such as ethyl acetate, butyl acetate, ethylcellosolve acetate, methyl benzoate, phenyl acetate, and the like; polyhydric alcohol solvents such as ethylene glycol, glycerin, 1,2-hexanediol, and the like; alcohol solvents such as methanol, ethanol, isopropyl alcohol, cyclohexanol, and the like; sulfoxide solvents such as dimethyl sulfoxide, and the like; amide solvents such as N-methyl-2-pyrrolidone, N,N-dimethylformamide, and the like; and water. The solvent may be used only singly or in combination of two or more.

The solvent is preferably an organic solvent, and is more preferably the same as the organic solvent used as a solvent in the above-described first step.

The concentration of a compound represented by the formula (M-1) or a compound represented by the formula (M-2) in a mixture (solution, suspension, or the like) to be additionally added is usually 0.01 to 50% by mass, and preferably 1 to 10% by mass.

The use amount of the solvent is usually 10 parts by mass or more and 100000 parts by mass or less, with respect to 100 parts by mass of a compound represented by the formula (M-1) or a compound represented by the formula (M-2) to be additionally added in the second step A.

Although the reason why the generation of an ultra-high molecular weight component can be effectively suppressed in the second step A is not necessarily clear, it is considered that when the monomer is introduced into a reaction solution as a solid, an ultra-high concentration monomer region is locally formed and diffusion becomes difficult, therefore, the polymerization reaction proceeds rapidly and an ultra-high molecular weight component is easily generated, while when the monomer is introduced into a reaction liquid in the state of a mixture (solution, suspension, etc.) diluted with a solvent, it is diffused in the reaction liquid, therefore, the homogenization rate of the monomer becomes larger than the polymerization reaction rate of the monomer, and the generation of the ultra-high molecular weight component is suppressed. The same effect is exhibited also in second steps D, E and G, which will be described later, involving this second step A.

### [Second step B]

The second step B is a step of additionally adding a compound represented by the formula (M-1) or a compound represented by the formula (M-2) to a reaction liquid containing the above-described first polymer after lowering the reaction temperature by 10°C or more, and polymerization-reacting them, to obtain a second polymer having larger polystyrene-equivalent weight-average molecular weight than that of the above-described first polymer.

In additionally adding a compound represented by the formula (M-1) or a compound represented by the formula (M-2) in the second step B, it is preferable to lower the reaction temperature by 10°C or more and 100°C or less, it is more preferable to lower the reaction temperature by 20°C or more and 80°C or less, and it is further preferable to lower the reaction temperature by 30°C or more and 60°C or less.

Although the reason why the generation of an ultra-high molecular weight component can be effectively suppressed in the second step B is not necessarily clear, it is considered that when the reaction temperature is lowered, the reaction rate of the monomer becomes sufficiently smaller than the homogenization rate of the monomer, therefore, the generation of the ultra-high molecular weight component is suppressed. The same effect is exhibited also in second steps D, F and G, which will be described later, involving this second step B.

### [Second step C]

The second step C is a step of additionally adding a compound represented by the formula (M-1) or a compound represented by the formula (M-2) to a reaction liquid containing the above-described first polymer after lowering the stirring revolution by 20% or more, and polymerization-reacting them, to obtain a second polymer having larger polystyrene-equivalent weight-average molecular weight than that of the above-described first polymer.

In additionally adding a compound represented by the formula (M-1) or a compound represented by the formula (M-2) in the second step C, it is preferable to lower the stirring revolution by 20% or more and 100% or less, it is more preferable to lower the stirring revolution by 30% or more and 90% or less, and it is further preferable to lower the stirring revolution by 40% or more and 80% or less. Reducing the stirring revolution by 100% means stopping the stirring.

In the second step C, especially in the case of a polymerization reaction of the two-layer system containing an aqueous layer and an organic layer, the generation of an ultra-high molecular weight component can be effectively suppressed. Though the reason for this is not necessarily clear, it is supposed that when the stirring revolution is low, the reaction liquid tends to be separated into two layers and an organic layer becomes a continuous layer, therefore, if the monomer is additionally added in this state, the homogenization rate of the monomer in the organic layer becomes larger than the polymerization reaction rate, thus, the generation of an ultra-high molecular weight component is suppressed. The same effect is exhibited also in second steps E, F and G, which will be described later, involving this second step C.

### [Second step D]

The second step D is a step of additionally adding a mixture of a compound represented by the formula (M-1) or a compound represented by the formula (M-2) and a solvent to a reaction liquid containing the above-described first polymer after lowering the reaction temperature by 10°C or more, and polymerization-reacting them, to obtain a second polymer having larger polystyrene-equivalent weight-average molecular weight than that of the above-described first polymer.

The examples, the preferable range and the use amount of the solvent are the same as in the second step A.

The reaction temperature and the preferable range in additionally adding a compound represented by the formula (M-1) or a compound represented by the formula (M-2) are the same as in the second step B.

### [Second step E]

The second step E is a step of additionally adding a mixture of a compound represented by the formula (M-1) or a compound represented by the formula (M-2) and a solvent to a reaction liquid containing the above-described first polymer after lowering the stirring revolution by 20% or more, and polymerization-reacting them, to obtain a second polymer having larger polystyrene-equivalent weight-average molecular weight than that of the above-described first polymer.

The examples, the preferable range and the use amount of the solvent are the same as in the second step A.

The stirring revolution and the preferable range in additionally adding a compound represented by the formula (M-1) or a compound represented by the formula (M-2) are the same as in the second step C.

### [Second step F]

The second step F is a step of additionally adding a compound represented by the formula (M-1) or a compound represented by the formula (M-2) to a reaction liquid containing the above-described first polymer after lowering the reaction temperature by 10°C or more and lowering the stirring revolution by 20% or more, and polymerization-reacting them, to obtain a second polymer having larger polystyrene-equivalent weight-average molecular weight than that of the above-described first polymer.

The reaction temperature and the preferable range in additionally adding a compound represented by the formula (M-1) or a compound represented by the formula (M-2) are the same as in the second step B.

The stirring revolution and the preferable range in additionally adding a compound represented by the formula (M-1) or a compound represented by the formula (M-2) are the same as in the second step C.

### [Second step G]

The second step G is a step of additionally adding a mixture of a compound represented by the formula (M-1) or a compound represented by the formula (M-2) and a solvent to a reaction liquid containing the above-described first polymer after lowering the reaction temperature by 10°C or more and lowering the stirring revolution by 20% or more, and polymerization-reacting them, to obtain a second polymer having larger polystyrene-equivalent weight-average molecular weight than that of the above-described first polymer.

The examples, the preferable range and the use amount of the solvent are the same as in the second step A.

The reaction temperature and the preferable range in additionally adding a compound represented by the formula (M-1) or a compound represented by the formula (M-2) are the same as in the second step B.

The stirring revolution and the preferable range in additionally adding a compound represented by the formula (M-1) or a compound represented by the formula (M-2) are the same as in the second step C.

The post treatment of the polymerization reaction can be carried out using known methods, for example, a method of removing water-soluble impurities by liquid separation, a method in which a reaction liquid after the reaction is added to a lower alcohol such as methanol, or the like to deposit a precipitate, and the precipitate is filtrated, then, dried; and other methods, singly or in combination.

When the purity of the polymer compound is low, it can be purified by usual methods such as, for example, crystallization, reprecipitation, continuous extraction with Soxhlet extractor, column chromatography, and the like.

### 3.2 Production method of polymer compound containing constitutional unit represented by the formula (U-1) and constitutional unit represented by the formula (U-3)

In the production method of the present invention, a polymer compound containing a constitutional unit represented by the formula (U-1) and a constitutional unit represented by the formula (U-3) in which Mz/Mw is 1 or more and less than 3 can be obtained. Typically mentioned is a method of using a compound represented by the formula (M-1) and a compound represented by the formula (M-3) as raw material monomers and polymerizing them by the Buchwald-Hartwig reaction.

The production method of the present invention can be carried out in the same manner as in or according to 3.1 (I) First step and (II) Second step described above.

### (I) First step

The first step is a step of polymerization-reacting a compound represented by the formula (M-1) and a compound represented by the formula (M-3), in the presence of a catalyst, a base and a solvent, to obtain a first polymer. The detailed procedure can be carried out in the same manner as in or according to 3.1 (I) First step.

The explanation and the preferable examples of Ar^{a1}, Ar^{a2}, Ar^{a3}, Ar^{c1}, Ar^{c2}, Ar^{c3}, R^{a1}, R^{a2}, R^{c1}, R^{c2}, R^{c3}, R^{c4}, a1, a2, c1, c2 and c3 in a compound represented by the formula (M-1) and a compound represented by the formula (M-3) are the same as the explanation and the preferable examples for a constitutional unit represented by the formula (U-1) and a constitutional unit represented by the formula (U-3).

Z^{a1} and Z^{a2} represent preferably a chlorine atom or a bromine atom, and more preferably a bromine atom.

The compound represented by the formula (M-3) includes, for example, compounds represented by the formula (XXX-1) to formula (XXX-8), and compounds represented by the formula (XXX-1) to formula (XXX-6) are preferred, and compounds represented by the formula (XXX-1) to formula (XXX-3) are more preferred. 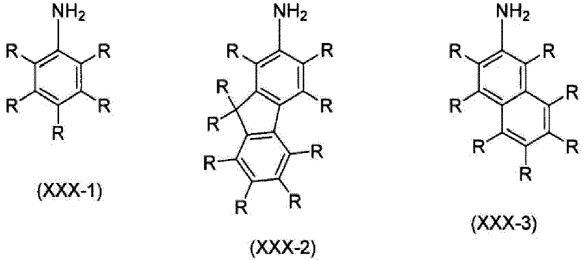 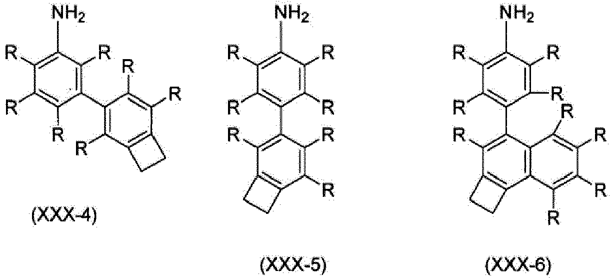 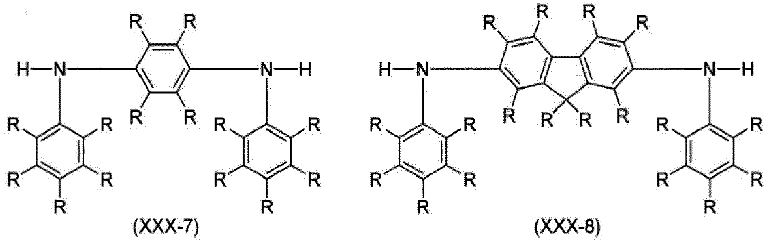 [wherein, R represents the same meaning as described above.].

The first polymer has a polystyrene-equivalent weight-average molecular weight of usually 1×10³ to 1×10⁸, and its Mz/Mw is usually 1 or more and less than 3.

In the first step, "other compounds" than a compound represented by the formula (M-1) and a compound represented by the formula (M-3) may be further polymerization-reacted.

"The other compound" includes, for example, compounds represented by the formula (YY-1) to formula (YY-8), and compounds represented by the formula (YY-1) to formula (YY-3), and the formula (YY-5) to formula (YY-7) are preferred, and compounds represented by the formula (YY-1) to formula (YY-3) are more preferred.

### (II) Second step

The second step is a step of further additionally adding a compound represented by the formula (M-1) or a compound represented by the formula (M-3), and polymerization-reacting them, in the presence of a catalyst, a base and a solvent, to obtain a second polymer having larger polystyrene-equivalent weight-average molecular weight than that of the first polymer, and can be classified into, for example, a second step A to a second step G.

The amount of a compound represented by the formula (M-1) or a compound represented by the formula (M-3) to be additionally added in the second step is preferably 0.01 parts by mass or more and 30 parts by mass or less, more preferably 0.03 parts by mass or more and 10 parts by mass or less, and further preferably 0.1 parts by mass or more and 3 parts by mass or less, with respect to 100 parts by mass of the total amount of a compound represented by the formula (M-1) and a compound represented by the formula (M-3) used in the first step.

The polystyrene-equivalent weight-average molecular weight of the second polymer is larger than that of the first polymer, and it is 1×10³ to 1×10⁸, with Mz/Mw being 1 or more and less than 3.

### [Second step A]

The second step A is a step of additionally adding a mixture of a compound represented by the formula (M-1) or a compound represented by the formula (M-3) and a solvent to a reaction liquid containing the above-described first polymer, and polymerization-reacting them, to obtain a second polymer having larger polystyrene-equivalent weight-average molecular weight than that of the above-described first polymer. This step A can be carried out in the same manner as in 3.1 [Second step A] described above.

### [Second step B]

The second step B is a step of additionally adding a compound represented by the formula (M-1) or a compound represented by the formula (M-3) to a reaction liquid containing the above-described first polymer after lowering the reaction temperature by 10°C or more, and polymerization-reacting them, to obtain a second polymer having larger polystyrene-equivalent weight-average molecular weight than that of the above-described first polymer. This step B can be carried out in the same manner as in 3.1 [Second step B] described above.

### [Second step C]

The second step C is a step of additionally adding a compound represented by the formula (M-1) or a compound represented by the formula (M-3) to a reaction liquid containing the above-described first polymer after lowering the stirring revolution by 20% or more, and polymerization-reacting them, to obtain a second polymer having larger polystyrene-equivalent weight-average molecular weight than that of the above-described first polymer. This step C can be carried out in the same manner as in 3.1 [Second step C] described above.

### [Second step D]

The second step D is a step of additionally adding a mixture of a compound represented by the formula (M-1) or a compound represented by the formula (M-3) and a solvent to a reaction liquid containing the above-described first polymer after lowering the reaction temperature by 10°C or more, and polymerization-reacting them, to obtain a second polymer having larger polystyrene-equivalent weight-average molecular weight than that of the above-described first polymer. This step D can be carried out in the same manner as in 3.1 [Second step D] described above.

### [Second step E]

The second step E is a step of additionally adding a mixture of a compound represented by the formula (M-1) or a compound represented by the formula (M-3) and a solvent to a reaction liquid containing the above-described first polymer after lowering the stirring revolution by 20% or more, and polymerization-reacting them, to obtain a second polymer having larger polystyrene-equivalent weight-average molecular weight than that of the above-described first polymer. This step E can be carried out in the same manner as in 3.1 [Second step E] described above.

### [Second step F]

The second step F is a step of additionally adding a compound represented by the formula (M-1) or a compound represented by the formula (M-3) to a reaction liquid containing the above-described first polymer after lowering the reaction temperature by 10°C or more and lowering the stirring revolution by 20% or more, and polymerization-reacting them, to obtain a second polymer having larger polystyrene-equivalent weight-average molecular weight than that of the above-described first polymer. This step F can be carried out in the same manner as in 3.1 [Second step F] described above.

### [Second step G]

The second step G is a step of additionally adding a mixture of a compound represented by the formula (M-1) or a compound represented by the formula (M-3) and a solvent to a reaction liquid containing the above-described first polymer after lowering the reaction temperature by 10°C or more and lowering the stirring revolution by 20% or more, and polymerization-reacting them, to obtain a second polymer having larger polystyrene-equivalent weight-average molecular weight than that of the above-described first polymer. This step G can be carried out in the same manner as in 3.1 [Second step G] described above.

Also the post treatment of the polymerization reaction and the purification thereof can be carried out in the same manner as in the above-described 3.1.

### 4. Light emitting device

The light emitting device of the present embodiment is a light emitting device having an anode, a cathode, and an organic layer formed using a polymer compound produced by the above-described production method disposed between the anode and the cathode. The organic layer includes, for example, a light emitting layer, a hole transporting layer, a hole injection layer, an electron transporting layer, an electron injection layer, and the like. At least one of these layers is formed using the above-described polymer compound.

The light emitting device can be produced, specifically, by forming between an anode and a cathode an organic layer using a composition containing (a) a polymer compound produced by the above-described production method, (b) at least one compound selected from the group consisting of a light emitting compound, a charge transporting compound and a charge injection compound, different from the above-described polymer compound, and (c) a solvent.

The above-described polymer compound may contain a group having a chemical structure of benzocyclobutene, alkene, epoxy, oxetane or the like forming a crosslinked structure by a crosslinking reaction (hereinafter, referred to as cross-linkable group), and by forming an organic layer using a polymer compound having a cross-linkable group, then, crosslinking the cross-linkable group, the organic layer can be insolubilized. By insolubilizing the organic layer as described above, even if the material of the organic layer is soluble in a solvent which is used in forming a layer adjacent to the organic layer in a light emitting device, the dissolution of the material can be avoided.

The organic layer included in the light emitting device of the present embodiment may also be an organic layer containing a polymer compound which is formed not via a step of insolubilization owing to crosslinking or the like.

### [Layer constitution]

The organic layer formed using the above-described polymer compound is usually at least one layer selected from the group consisting of a light emitting layer, a hole transporting layer, a hole injection layer, an electron transporting layer and an electron injection layer, and is preferably a hole transporting layer.

These layers contains a light emitting material, a hole transporting material, hole injection material, an electron transporting material and an electron injection material, respectively. These layers can be formed by dissolving a light emitting material, a hole transporting material, a hole injection material, an electron transporting material and an electron injection material in the above-described solvents, respectively, to prepare inks, and performing a method such as a spin coat method and the like using the prepared inks.

A light emitting device has a light emitting layer between an anode and a cathode. The light emitting device of the present embodiment preferably has one of a hole injection layer and a hole transporting layer between an anode and a light emitting layer from the standpoint of hole injectability and hole transportability, and preferably has at least one of an electron injection layer and an electron transporting layer between a cathode and a light emitting layer from the standpoint of electron injectability and electron transportability.

As the materials of a hole transporting layer, an electron transporting layer, a light emitting layer, a hole injection layer and an electron injection layer, a hole transporting material, an electron transporting material, a light emitting material, a hole injection material and an electron injection material may be contained, respectively, in addition to the above-described polymer compound.

When the material of a hole transporting layer, the material of an electron transporting layer and the material of a light emitting layer are soluble in solvents used in forming layers adjacent to the hole transporting layer, the electron transporting layer and the light emitting layer, respectively, in fabrication of a light emitting layer, it is preferable that the materials have a cross-linkable group for avoiding dissolution of the materials in the solvents. By crosslinking the cross-linkable group after forming each layer using the material having the cross-linkable group, the layer can be insolubilized.

The method of forming each of a light emitting layer, a hole transporting layer, an electron transporting layer, a hole injection layer, an electron injection layer and the like in the light emitting device of the present embodiment includes, for example, a vacuum vapor deposition method from a powder and a method by film formation from a solution or melted state when a low molecular compound is used, and, for example, a method by film formation from a solution or melted state when a polymer compound is used. The order, number and thickness of layers to be laminated are adjusted in consideration of light emission efficiency and luminance life.

### [Substrate/electrode]

The substrate in the light emitting device may be a substrate on which electrodes can be formed and which does not chemically change when forming an organic layer and is, for example, a substrate made of a material such as glass, plastic, silicon, and the like. In the case of an opaque substrate, it is preferable that the electrode farthest from the substrate is transparent or semitransparent.

The anode material includes, for example, electrically conductive metal oxides and semitransparent metals, and preferably includes indium oxide, zinc oxide and tin oxide; electrically conductive compounds such as indium•tin•oxide (ITO), indium•zinc•oxide and the like; argentine-palladium-copper composite (APC); NESA, gold, platinum, silver, and copper.

The cathode material includes, for example, metals such as lithium, sodium, potassium, rubidium, cesium, beryllium, magnesium, calcium, strontium, barium, aluminum, zinc, indium and the like; alloys composed of two or more of them; alloys composed of one or more of them and one or more of silver, copper, manganese, titanium, cobalt, nickel, tungsten and tin; and, graphite and graphite intercalation compounds. The alloy includes, for example, a magnesium-silver alloy, a magnesium-indium alloy, a magnesium-aluminum alloy, an indium-silver alloy, a lithium-aluminum alloy, a lithium-magnesium alloy, a lithium-indium alloy, and a calcium-aluminum alloy.

The anode and the cathode each may take a laminated structure composed of two or more layers.

### [Applications]

The light emitting device of the present embodiment can be used, for example, for displays of computer, television, portable terminal and the like, and for illumination.

### EXAMPLES

Examples for illustrating the present invention further in detail will be shown below, but the present invention is not limited to them.

### <Analysis of molecular weight>

The polystyrene-equivalent weight-average molecular weight (Mw) and the polystyrene-equivalent z-average molecular weight (Mz) of a polymer compound were determined by gel permeation chromatography (GPC).
Analysis conditions are as described below.
Measurement apparatus: HLC-8320 GPC (manufactured by Tosoh Corp.)
Column: PLgel 10 µm MIXED-B (manufactured by Tosoh Corp.)
Column temperature: 40°C
Mobile phase: tetrahydrofuran
Flow rate: 0.5 mL/min
Detection wavelength: 228 nm

### <Example 1>

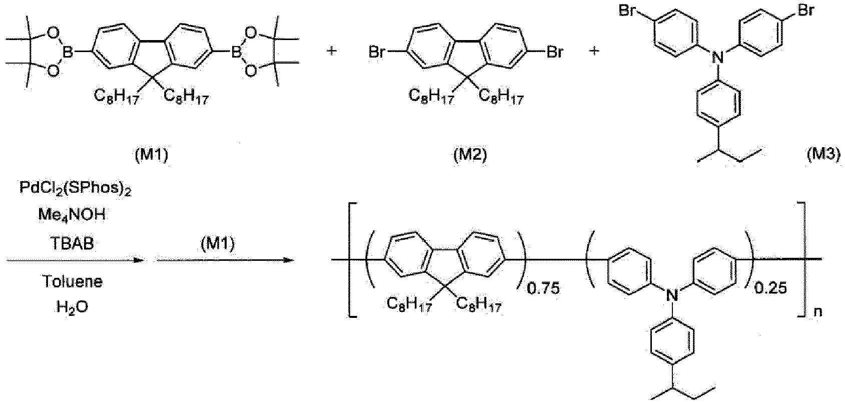

[wherein, n represents the number of repeating units.].

### [First step]

A nitrogen gas atmosphere was prepared in a reaction vessel, then, a compound M1 (2.35 g, 3.66 mmol), a compound M2 (1.18 g, 2.15 mmol), a compound M3 (0.99 g, 2.15 mmol), dichlorobis(2-dicyclohexylphosphino-2',6'-dimethoxy-1,1'-biphenyl)palladium(II) (2.15 mg), toluene (30 g), tetrabutylammonium bromide (0.14 g, 0.43 mmol) and a 22% by mass tetramethylammonium hydroxide aqueous solution (38 g, 91 mmol) were added, and they were reacted at 80°C for 2 hours. The mixture was stirred by a three swept-back wing (pfaudler blade), and the stirring revolution was 300 rpm. The resultant first polymer had Mw = 6.9×10⁴ and Mz/Mw = 1.8.

### [Second step A]

To the solution containing the first polymer obtained in the first step was added a solution containing a compound M1 (0.14 g, 0.22 mmol) and toluene (1.5 g) under conditions of a temperature of 80°C and a stirring revolution of 300 rpm. They were reacted at 80°C for 2 hours. The stirring revolution during the reaction was 300 rpm. The resultant second polymer had Mw = 1.0×10⁵ and Mz/Mw = 1.8.

### <Example 2>

### [First step]

It is as in Example 1.

### [Second step B]

The solution containing the first polymer obtained in the first step was cooled, and a compound M1 (0.14 g, 0.22 mmol) was added under conditions of a temperature of 40°C and a stirring revolution of 300 rpm. They were heated up to 80°C and reacted for 2 hours. The stirring revolution during the reaction was 300 rpm. The resultant second polymer had Mw = 1.0×10⁵ and Mz/Mw = 1.8.

### <Example 3>

### [First step]

It is as in Example 1.

### [Second step C]

The stirring revolution of the solution containing the first polymer obtained in the first step was lowered, and a compound M1 (0.14 g, 0.22 mmol) was added under conditions of a temperature of 80°C and a stirring revolution of 0 rpm. The stirring revolution was increased to 300 rpm, then, they were reacted at 80°C for 2 hours. The resultant second polymer had Mw = 1.0×10⁵ and Mz/Mw = 1.8.

### <Example 4>

### [First step]

It is as in Example 1.

### [Second step D]

The solution containing the first polymer obtained in the first step was cooled, and a solution containing a compound M1 (0.14 g, 0.22 mmol) and toluene (1.5 g) was added under conditions of a temperature of 40°C and a stirring revolution of 300 rpm. They were heated up to 80°C and reacted for 2 hours. The stirring revolution during the reaction was 300 rpm. The resultant second polymer had Mw = 1.0×10⁵ and Mz/Mw = 1.8.

### <Example 5>

### [First step]

It is as in Example 1.

### [Second step E]

The stirring revolution of the solution containing the first polymer obtained in the first step was lowered, and a solution containing a compound M1 (0.14 g, 0.22 mmol) and toluene (1.5 g) was added under conditions of a temperature of 80°C and a stirring revolution 50 rpm. The stirring revolution was increased to 300 rpm, then, they were reacted at 80°C for 2 hours. The resultant second polymer had Mw = 9.9×10⁴ and Mz/Mw = 1.8.

### <Example 6>

### [First step]

It is as in Example 1.

### [Second step F]

The solution containing the first polymer obtained in the first step was cooled, the stirring revolution was lowered, and a compound M1 (0.14 g, 0.22 mmol) was added under conditions of a temperature of 30°C and a stirring revolution 100 rpm. The temperature was raised up to 80°C, and the stirring revolution was increased to 300 rpm, then, they were reacted for 2 hours. The resultant second polymer had Mw = 1.0×10⁵ and Mz/Mw = 1.8.

### <Example 7>

### [First step]

It is as in Example 1.

### [Second step G]

The solution containing the first polymer obtained in the first step was cooled, the stirring revolution was lowered, and a solution containing a compound M1 (0.14 g, 0.22 mmol) and toluene (1.5 g) was added under conditions of a temperature of 50°C and a stirring revolution of 50 rpm. The temperature was raised up to 80°C and the stirring revolution was increased to 300 rpm, then, they were reacted for 2 hours. The resultant second polymer had Mw = 9.9×10⁴ and Mz/Mw = 1.8.

### <Comparative Example 1>

### [First step]

It is as in Example 1.

### [Second step]

To the solution containing the first polymer obtained in the first step was added a compound M1 (0.14 g, 0.22 mmol), under conditions of a temperature of 80°C and a stirring revolution of 300 rpm. They were reacted at 80°C for 2 hours. The stirring revolution was 300 rpm. The resultant second polymer had Mw = 1.5×10⁵ and Mz/Mw = 3.1.

The above results are shown in Table 1.

**[Table 1]**

| | | Example 1 (step A) | Example 2 (step B) | Example 3 (step C) | Example 4 (step D) | Example 5 (step E) | Example 6 (step F) | Example 7 (step G) | Comparative Example 1 |
|---|---|---|---|---|---|---|---|---|---|
| Reaction condition of second step | Temperature (°C) | 80 | 80 | 80 | 80 | 80 | 80 | 80 | 80 |
| | Stirring (rpm) | 300 | 300 | 300 | 300 | 300 | 300 | 300 | 300 |
| At the time of additionally adding compound M1 | condition | solution | solid | solid | solution | solution | solid | solution | solid |
| | Temperature (°C) | 80 | 40 | 80 | 40 | 80 | 30 | 50 | 80 |
| | Stirring (rpm) | 300 | 300 | 0 | 300 | 50 | 100 | 50 | 300 |
| First polymer (before additionally adding compound M1) | Mw | 6.9×10⁴ | 6.9×10⁴ | 6.9×10⁴ | 6.9×10⁴ | 6.9×10⁴ | 6.9×10⁴ | 6.9×10⁴ | 6.9×10⁴ |
| | Mz | 1.2×10⁵ | 1.2×10⁵ | 1.2×10⁵ | 1.2×10⁵ | 1.2×10⁵ | 1.2×10⁵ | 1.2×10⁵ | 1.2×10⁵ |
| | Mz/Mw | 1.8 | 1.8 | 1.8 | 1.8 | 1.8 | 1.8 | 1.8 | 1.8 |
| Second polymer | Mw | 1.0×10⁵ | 1.0×10⁵ | 1.0×10⁵ | 1.0×10⁵ | 9.9×10⁴ | 1.0×10⁵ | 9.9×10⁴ | 1.5×10⁵ |
| | Mz | 1.8×10⁵ | 1.8×10⁵ | 1.8×10⁵ | 1.8×10⁵ | 1.8×10⁵ | 1.8×10⁵ | 1.8×10⁵ | 4.7×10⁵ |
| | Mz/Mw | 1.8 | 1.8 | 1.8 | 1.8 | 1.8 | 1.8 | 1.8 | 3.1 |

### <Example 8>

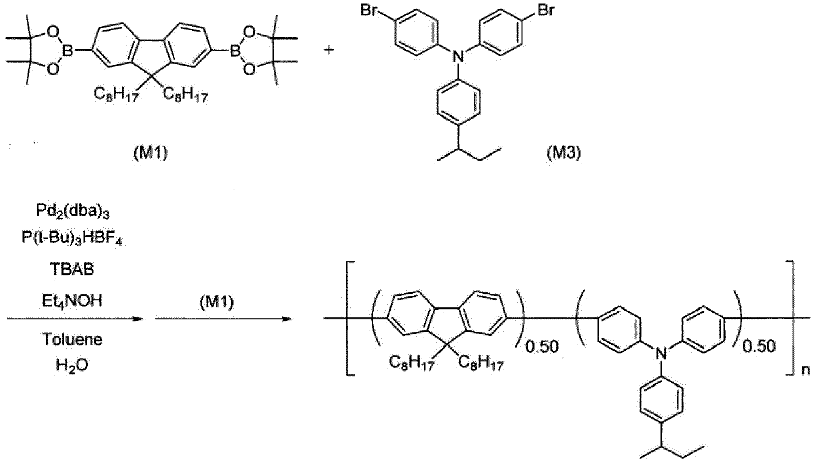

[wherein, n represents the number of repeating units.].

### [First step]

A nitrogen gas atmosphere was prepared in a reaction vessel, then, a compound M1 (1.23 g, 1.92 mmol), a compound M3 (0.92 g, 2.00 mmol), tris(dibenzylideneacetone)dipalladium(0) (55 mg), tri-tert-butylphosphonium tetrafluoroborate (70 mg), toluene (80 g), tetrabutylammonium bromide (0.13 g, 0.40 mmol) and a 17% by mass tetraethylammonium hydroxide aqueous solution (20 g, 40 mmol) were added, and they were reacted at 80°C for 2 hours. The mixture was stirred by a three swept-back wing (pfaudler blade), and the stirring revolution was 300 rpm. The resultant first polymer had Mw = 1.5×10⁵ and Mz/Mw = 1.8.

### [Second step A]

To the solution containing the first polymer obtained in the first step was added a solution containing a compound M1 (0.026 g, 0.040 mmol) and toluene (1.0 g) under conditions of a temperature of 80°C and a stirring revolution of 300 rpm. They were reacted at 80°C for 2 hours. The stirring revolution during the reaction was 300 rpm. The resultant second polymer had Mw = 2.1×10⁵ and Mz/Mw = 1.8.

### <Example 9>

### [First step]

It is as in Example 8.

### [Second step B]

The solution containing the first polymer obtained in the first step was cooled, and a compound M1 (0.026 g, 0.040 mmol) was added under conditions of a temperature of 40°C and a stirring revolution of 300 rpm. They were heated up to 80°C and reacted for 2 hours. The stirring revolution during the reaction was 300 rpm. The resultant second polymer had Mw = 2.1×10⁵ and Mz/Mw = 1.8.

### <Comparative Example 2>

### [First step]

It is as in Example 8.

### [Second step]

To the solution containing the first polymer obtained in the first step was added a compound M1 (0.026 g, 0.040 mmol) under conditions of a temperature of 80°C and a stirring revolution of 300 rpm. They were reacted at 80°C for 2 hours. The stirring revolution was 300 rpm. The resultant second polymer had Mw = 2.3×10⁵ and Mz/Mw = 3.2.

The above results are shown in Table 2.

**[Table 2]**

| | | Example 8 (step A) | Example 9 (step B) | Comparative Example 2 |
|---|---|---|---|---|
| Reaction of second step | Temperature (°C) | 80 | 80 | 80 |
| | Stirring (rpm) | 300 | 300 | 300 |
| At the time of additionally adding compound M1 | condition | solution | solid | solid |
| | Temperature (°C) | 80 | 40 | 80 |
| | Stirring (rpm) | 300 | 300 | 300 |
| First polymer (before additionally adding compound M1) | Mw | 1.5×10⁵ | 1.5×10⁵ | 1.5×10⁵ |
| | Mz | 2.7×10⁵ | 2.7×10⁵ | 2.7×10⁵ |
| | Mz/Mw | 1.8 | 1.8 | 1.8 |
| Second polymer | Mw | 2.1×10⁵ | 2.1×10⁵ | 2.3×10⁵ |
| | Mz | 3.8×10⁵ | 3.8×10⁵ | 7.4×10⁵ |
| | Mz/Mw | 1.8 | 1.8 | 3.2 |

### <Example 10>

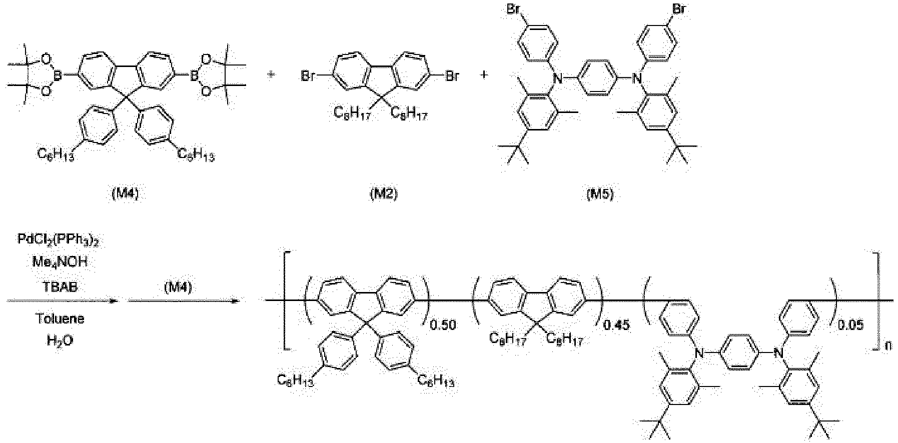

[wherein, n represents the number of repeating units.].

### [First step]

A nitrogen gas atmosphere was prepared in a reaction vessel, then, a compound M4 (4.87 g, 6.59 mmol), a compound M2 (3.36 g, 6.05 mmol), a compound M5 (0.50 g, 0.67 mmol), dichlorobis(triphenylphosphine)palladium(II) (2.36 mg), toluene (120 g), tetrabutylammonium bromide (0.22 g, 0.67 mmol) and a 16% by mass tetramethylammonium hydroxide aqueous solution (25 g, 44 mmol) were added, and the mixture was reacted at 80°C for 2 hours. The mixture was stirred by a three swept-back wing (pfaudler blade), and the stirring revolution was 500 rpm. The resultant first polymer had Mw = 2.1×10⁵ and Mz/Mw = 1.8.

### [Second step A]

To the solution containing the first polymer obtained in the first step was added a solution containing a compound M4 (0.025 g, 0.034 mmol) and toluene (2.0 g) under conditions of a temperature of 80°C and a stirring revolution of 500 rpm. They were reacted at 80°C for 2 hours. The stirring revolution during the reaction was 500 rpm. The resultant second polymer had Mw = 2.8×10⁵ and Mz/Mw = 1.8.

### <Comparative Example 3>

### [First step]

It is as in Example 10.

### [Second step]

To the solution containing the first polymer obtained in the first step was added a compound M4 (0.025 g, 0.034 mmol) under conditions of a temperature of 80°C and a stirring revolution of 500 rpm. They were reacted at 80°C for 2 hours. The stirring revolution was 500 rpm. The resultant second polymer had Mw = 3.3×10⁵ and Mz/Mw = 5.3.

The above results are shown in Table 3.

**[Table 3]**

| | | Example 10 (step A) | Comparative Example 3 |
|---|---|---|---|
| Reaction of | Temperature (°C) | 80 | 80 |
| second step | Stirring (rpm) | 500 | 500 |
| At the time of additionally adding compound M4 | condition | solution | solid |
| | Temperature (°C) | 80 | 80 |
| | Stirring (rpm) | 500 | 500 |
| First polymer (before additionally adding compound M4) | Mw | 2.1×10⁵ | 2.1×10⁵ |
| | Mz | 3.8×10⁵ | 3.8×10⁵ |
| | Mz/Mw | 1.8 | 1.8 |
| Second polymer | Mw | 2.8×10⁵ | 3.3×10⁵ |
| | Mz | 5.0×10⁵ | 1.7×10⁵ |
| | Mz/Mw | 1.8 | 5.3 |

### <Example 11>

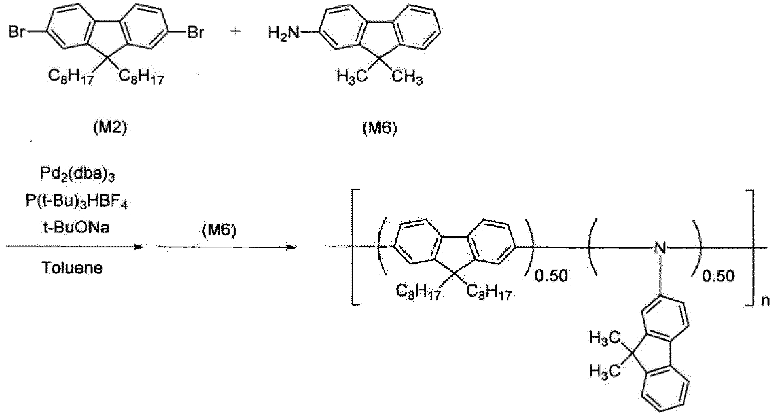

[wherein, n represents the number of repeating units.].

### [First step]

A nitrogen gas atmosphere was prepared in a reaction vessel, then, a compound M2 (0.15 g, 0.72 mmol), a compound M6 (0.31 g, 0.57 mmol), tris(dibenzylideneacetone)dipalladium(0) (20 mg), tri-tert-butylphosphonium tetrafluoroborate (25 mg), toluene (15 g), and tertiary butoxysodium (0.28 g, 2.9 mmol) were added, and they were reacted at 60°C for 2 hours. The mixture was stirred by a magnetic stirrer, and the stirring revolution was 500 rpm. The resultant first polymer had Mw = 4.1×10³ and Mz/Mw = 1.7.

### [Second step A]

To the solution containing the first polymer obtained in the first step was added a solution containing a compound M2 (0.030 g, 0.057 mmol) and toluene (1.0 g) under conditions of a temperature of 60°C and a stirring revolution of 500 rpm. They were reacted at 60°C for 2 hours. The stirring revolution during the reaction was 500 rpm. The resultant second polymer had Mw = 4.2×10⁴ and Mz/Mw = 1.7.

### <Comparative Example 4>

### [First step]

It is as in Example 12.

### [Second step]

To the solution containing the first polymer obtained in the first step was added a compound M2 (0.030 g, 0.057 mmol) under conditions of a temperature of 60°C and a stirring revolution of 500 rpm. They were reacted at 60°C for 2 hours. The stirring revolution was 500 rpm. The resultant second polymer had Mw = 5.2×10⁴ and Mz/Mw = 3.3.

The above results are shown in Table 4.

**[Table 4]**

| | | Example 11 (step A) | Comparative Example 4 |
|---|---|---|---|
| Reaction of second step | Temperature (°C) | 60 | 60 |
| | Stirring (rpm) | 500 | 500 |
| At the time of additionally adding compound M2 | condition | solution | solid |
| | Temperature (°C) | 60 | 60 |
| | Stirring (rpm) | 500 | 500 |
| First polymer (before additionally adding compound M2) | Mw | 4.1×10³ | 4.1×10³ |
| | Mz | 7.0×10³ | 7.0×10³ |
| | Mz/Mw | 1.7 | 1.7 |
| Second polymer | Mw | 4.2×10⁴ | 5.2×10⁴ |
| | Mz | 7.1×10⁴ | 1.7×10⁵ |
| | Mz/Mw | 1.7 | 3.3 |

### <Evaluation of inkjet>

### <Example 12> Preparation of ink composition A

Cyclohexylbenzene (manufactured by Tokyo Chemical Industry Co., Ltd.) and 4-methylanisole (manufactured by Tokyo Chemical Industry Co., Ltd.) were mixed at a ratio of (79.5% by mass):(20.5% by mass), to prepare a mixed solvent. The prepared mixed solvent and the polymer obtained in Example 10 were mixed, to prepare a 0.5% by mass ink 1. Further, the above-described mixed solvent and an iridium complex represented by the following formula (MC-1) were mixed, to prepare a 0.5% by mass ink 2. The prepared ink 1 and ink 2 were mixed at a ratio of (50% by mass):(50% by mass), to prepare an ink composition A.

### <Comparative Example 5>Preparation of ink composition B

Cyclohexylbenzene (manufactured by Tokyo Chemical Industry Co., Ltd.) and 4-methylanisole (manufactured by Tokyo Chemical Industry Co., Ltd.) were mixed at a ratio of (79.5% by mass):(20.5% by mass), to prepare a mixed solvent. The prepared mixed solvent and the polymer obtained in Comparative Example 3 were mixed, to prepare a 0.5% by mass ink 3. Further, the mixed solvent and an iridium complex represented by the following formula (MC-1) were mixed, to prepare a 0.5% by mass ink 2. The prepared ink 3 and ink 2 were mixed at a ratio of (50% by mass):(50% by mass), to prepare an ink composition B.

### <Example 13> Evaluation of dischargeability of ink composition A

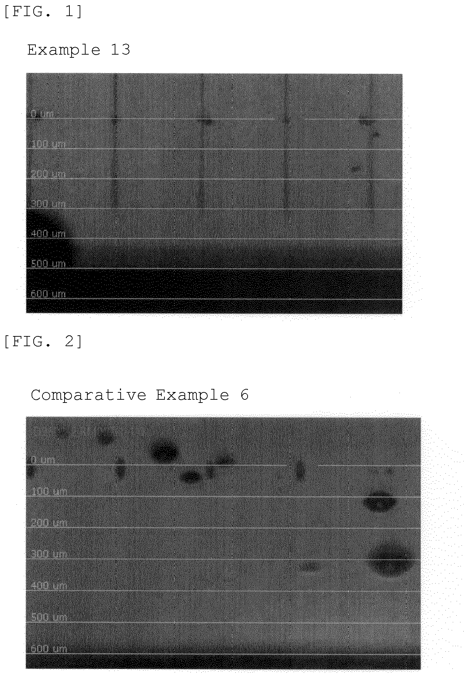

The ink composition A was injected into an inkjet cartridge (model number: DMC-11610, discharge amount: 10 pL, manufactured by FUJIFILM Dimatix, Inc.), and the cartridge was set in an inkjet apparatus DMP-2831 (manufactured by FUJIFILM Dimatix, Inc.). The heater of the inkjet cartridge was set at 25°C, and the piezo voltage was 40 V and the drive frequency was 1 kHz. The discharge hole was observed by a camera of the apparatus, and the flight shape of droplets of the discharged ink composition A was observed, to resultantly confirm that stable discharge was possible. See FIG. 1.

### <Comparative Example 6>Evaluation of dischargeability of ink composition B

As a result of evaluating the ink composition B in the same manner as in Example 13, the ink composition B could not be discharged. See FIG. 2.

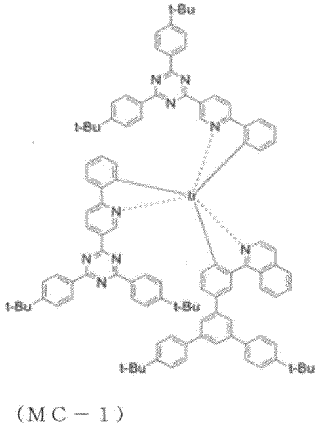

### Industrial Applicability

The present invention can provide a composition containing a polymer compound excellent in inkjet dischargeability. Further, a production method of the polymer compound and a production method of a light emitting device using the polymer compound can be provided.

## Claims

1. A composition comprising
(a) a polymer compound containing a constitutional unit represented by the formula (U-1) and a constitutional unit represented by the formula (U-2), wherein the ratio (Mz/Mw) of the polystyrene-equivalent z-average molecular weight (Mz) to the polystyrene-equivalent weight-average molecular weight (Mw) in the polymer compound is 1 or more and less than 3,
(b) at least one compound selected from the group consisting of a light emitting compound, a charge transporting compound and a charge injection compound, different from said polymer compound, and
(c) a solvent: 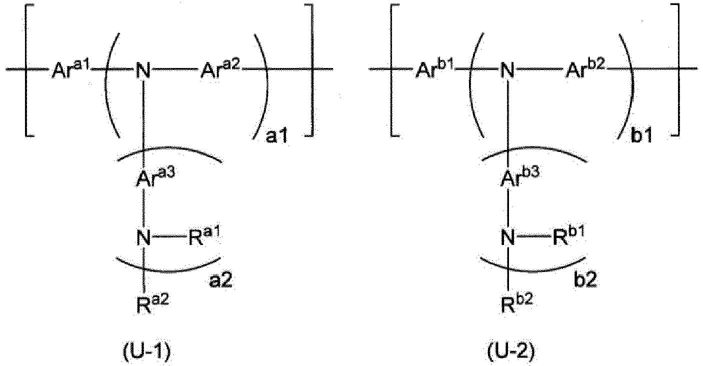 wherein,
Ar^{a1}, Ar^{a2}, Ar^{a3}, Ar^{b1}, Ar^{b2} and Ar^{b3} each independently represent a divalent aromatic hydrocarbon group, a divalent hetero ring group, or a divalent group in which two or more groups of divalent aromatic hydrocarbon groups and divalent hetero ring groups are connected directly or via a connecting group, and these groups optionally have a substituent, when a plurality of Ar^{a2}, Ar^{a3}, Ar^{b2} and Ar^{b3} are present, they may be the same or different at each occurrence,
R^{a1}, R^{a2}, R^{b1} and R^{b2} each independently represent an alkyl group, an aryl group or a monovalent hetero ring group, and these groups optionally have a substituent, when a plurality of R^{a1}, R^{a2}, R^{b1} and R^{b2} are present, they may be the same or different at each occurrence,
a1 and b1 each independently represent 0, 1 or 2,
a2 and b2 each independently represent 0 or 1, when a plurality of a2 and b2 are present, they may be the same or different at each occurrence.

2. A method of producing a polymer compound containing a constitutional unit represented by the formula (U-1) and a constitutional unit represented by the formula (U-2) in which the ratio (Mz/Mw) of the polystyrene-equivalent z-average molecular weight (Mz) to the polystyrene-equivalent weight-average molecular weight (Mw) in the polymer compound is 1 or more and less than 3, comprising the following steps (I) and (II);
(I) a first step of polymerization-reacting a compound represented by the formula (M-1) and a compound represented by the formula (M-2), in the presence of a catalyst, a base and a solvent, to obtain a first polymer, and
(II) a second step of obtaining a second polymer having larger polystyrene-equivalent weight-average molecular weight than that of said first polymer by adopting any of the following steps (A) to (G),
(A) a step of additionally adding a mixture containing a compound represented by the formula (M-1) or a compound represented by the formula (M-2) and a solvent to said first polymer, and polymerization-reacting them,
(B) a step of additionally adding a compound represented by the formula (M-1) or a compound represented by the formula (M-2) to said first polymer after lowering the reaction temperature by 10°C or more than in the first step, and thereafter, raising the reaction temperature by 10°C or more and polymerization-reacting them,
(C) a step of additionally adding a compound represented by the formula (M-1) or a compound represented by the formula (M-2) to said first polymer after lowering the stirring revolution by 20% or more than in the first step, and thereafter, increasing the stirring revolution by 20% or more and polymerization-reacting them,
(D) a step of additionally adding a mixture containing a compound represented by the formula (M-1) or a compound represented by the formula (M-2) and a solvent to said first polymer after lowering the reaction temperature by 10°C or more than in the first step, and thereafter, raising the reaction temperature by 10°C or more and polymerization-reacting them,
(E) a step of additionally adding a mixture containing a compound represented by the formula (M-1) or a compound represented by the formula (M-2) and a solvent to said first polymer after lowering the stirring revolution by 20% or more than in the first step, and thereafter, increasing the stirring revolution by 20% or more and polymerization-reacting them,
(F) a step of additionally adding a compound represented by the formula (M-1) or a compound represented by the formula (M-2) to said first polymer after lowering the reaction temperature by 10°C or more and lowering the stirring revolution by 20% or more than in the first step, and thereafter, raising the reaction temperature by 10°C or more and increasing the stirring revolution by 20% or more and polymerization-reacting them, and
(G) a step of additionally adding a mixture containing a compound represented by the formula (M-1) or a compound represented by the formula (M-2) and a solvent to said first polymer after lowering the reaction temperature by 10°C or more and lowering the stirring revolution by 20% or more than in the first step, and thereafter, raising the reaction temperature by 10°C or more and increasing the stirring revolution by 20% or more and polymerization-reacting them: 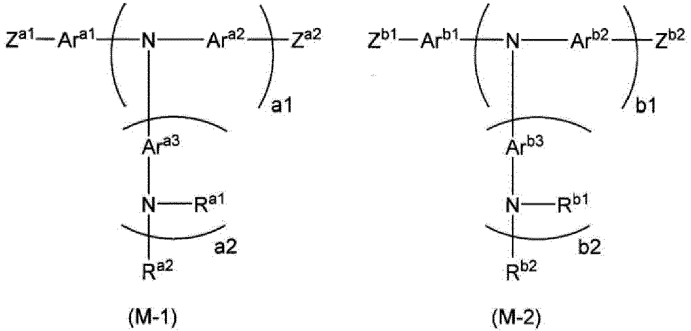 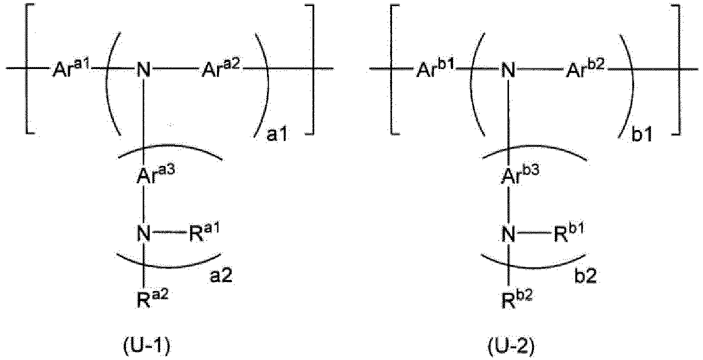 wherein,
Ar^{a1}, Ar^{a2}, Ar^{a3}, Ar^{b1}, Ar^{b2} and Ar^{b3} each independently represent a divalent aromatic hydrocarbon group, a divalent hetero ring group, or a divalent group in which two or more groups of divalent aromatic hydrocarbon groups and divalent hetero ring groups are connected directly or via a connecting group, and these groups optionally have a substituent, when a plurality of Ar^{a2}, Ar^{a3}, Ar^{b2} and Ar^{b3} are present, they may be the same or different at each occurrence,
R^{a1}, R^{a2}, R^{b1} and R^{b2} each independently represent an alkyl group, an aryl group or a monovalent hetero ring group, and these groups optionally have a substituent, when a plurality of R^{a1}, R^{a2}, R^{b1} and R^{b2} are present, they may be the same or different at each occurrence,
a1 and b1 each independently represent 0, 1 or 2,
a2 and b2 each independently represent 0 or 1,
Z^{a1} and Z^{a2} each independently represent a chlorine atom, a bromine atom, an iodine atom, -O-S(=O)₂R^{Z}, - S(=O)₂Cl, -S(=O)₂R^{Z}, -N₂⁺BF₄⁻, -SR^{Z}, -NR^{Z}₃⁺OTf⁻, -OR^{Z}, -O-C(=O)R^{Z} or -C(=O)-OR^{Z}, R^{Z} represents an alkyl group, an aryl group or a monovalent hetero ring group, and these groups optionally have a substituent, when a plurality of R^{Z} are present, they may be the same or different,
Z^{b1} and Z^{b2} each independently represent a hydrogen atom, -B(OH)₂, a boric acid ester residue or -BF₃T, and T represents a lithium atom, a sodium atom, a potassium atom, a rubidium atom or a cesium atom.

3. The production method of a polymer compound according to claim 2, wherein said second step is any of said steps (A) to (D).

4. A composition comprising
(a) a polymer compound containing a constitutional unit represented by the formula (U-1) and a constitutional unit represented by the formula (U-3), wherein the ratio (Mz/Mw) of the polystyrene-equivalent z-average molecular weight (Mz) to the polystyrene-equivalent weight-average molecular weight (Mw) in the polymer compound is 1 or more and less than 3,
(b) at least one compound selected from the group consisting of a light emitting compound, a charge transporting compound and a charge injection compound, different from said polymer compound, and
(c) a solvent: 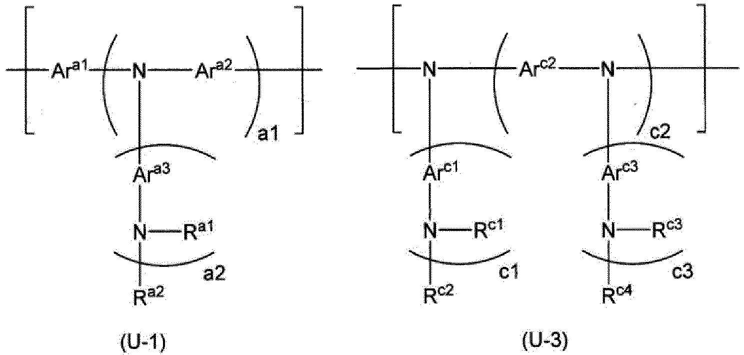 wherein,
Ar^{a1}, Ar^{a2}, Ar^{a3}, Ar^{c1}, Ar^{c2} and Ar^{c3} each independently represent a divalent aromatic hydrocarbon group, a divalent hetero ring group, or a divalent group in which two or more groups of divalent aromatic hydrocarbon groups and divalent hetero ring groups are connected directly or via a connecting group, and these groups optionally have a substituent, when a plurality of Ar^{a2} and Ar^{a3} are present, they may be the same or different at each occurrence,
R^{a1}, R^{a2}, R^{c1}, R^{c2}, R^{c3} and R^{c4} each independently represent an alkyl group, an aryl group or a monovalent hetero ring group, and these groups optionally have a substituent, when a plurality of R^{a1} and R^{a2} are present, they may be the same or different at each occurrence,
a1 represents 0, 1 or 2,
a2, c1, c2 and c3 each independently represent 0 or 1.

5. A method of producing a polymer compound containing a constitutional unit represented by the formula (U-1) and a constitutional unit represented by the formula (U-3) in which the ratio (Mz/Mw) of the polystyrene-equivalent z-average molecular weight (Mz) to the polystyrene-equivalent weight-average molecular weight (Mw) in the polymer compound is 1 or more and less than 3, comprising the following steps (I) and (II);
(I) a first step of polymerization-reacting a compound represented by the formula (M-1) and a compound represented by the formula (M-3), in the presence of a catalyst, a base and a solvent, to obtain a first polymer, and
(II) a second step of obtaining a second polymer having larger polystyrene-equivalent weight-average molecular weight than that of said first polymer by adopting any of the following steps (A) to (G),
(A) a step of additionally adding a mixture containing a compound represented by the formula (M-1) or a compound represented by the formula (M-3) and a solvent to said first polymer, and polymerization-reacting them,
(B) a step of additionally adding a compound represented by the formula (M-1) or a compound represented by the formula (M-3) to said first polymer after lowering the reaction temperature by 10°C or more than in the first step, and thereafter, raising the reaction temperature by 10°C or more and polymerization-reacting them,
(C) a step of additionally adding a compound represented by the formula (M-1) or a compound represented by the formula (M-3) to said first polymer after lowering the stirring revolution by 20% or more than in the first step, and thereafter, increasing the stirring revolution by 20% or more and polymerization-reacting them,
(D) a step of additionally adding a mixture containing a compound represented by the formula (M-1) or a compound represented by the formula (M-3) and a solvent to said first polymer after lowering the reaction temperature by 10°C or more than in the first step, and thereafter, raising the reaction temperature by 10°C or more and polymerization-reacting them,
(E) a step of additionally adding a mixture containing a compound represented by the formula (M-1) or a compound represented by the formula (M-3) and a solvent to said first polymer after lowering the stirring revolution by 20% or more than in the first step, and thereafter, increasing the stirring revolution by 20% or more and polymerization-reacting them,
(F) a step of additionally adding a compound represented by the formula (M-1) or a compound represented by the formula (M-3) to said first polymer after lowering the reaction temperature by 10°C or more and lowering the stirring revolution by 20% or more than in the first step, and thereafter, raising the reaction temperature by 10°C or more and increasing the stirring revolution by 20% or more and polymerization-reacting them, and
(G) a step of additionally adding a mixture containing a compound represented by the formula (M-1) or a compound represented by the formula (M-3) and a solvent to said first polymer after lowering the reaction temperature by 10°C or more and lowering the stirring revolution by 20% or more than in the first step, and thereafter, raising the reaction temperature by 10°C or more and increasing the stirring revolution by 20% or more and polymerization-reacting them: 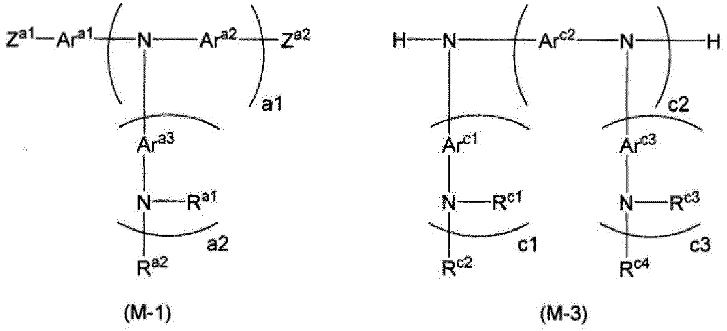 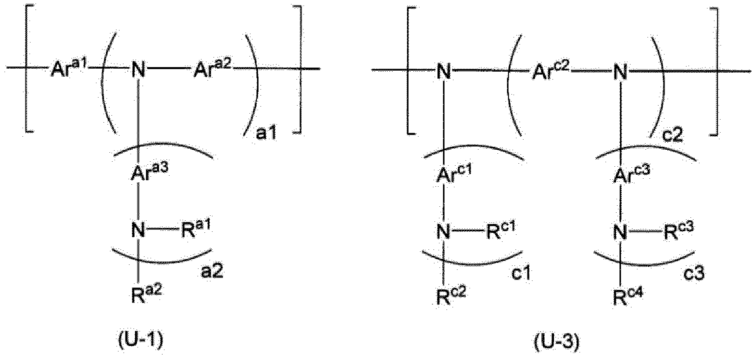 wherein,
Ar^{a1}, Ar^{a2}, Ar^{a3}, Ar^{c1}, Ar^{c2} and Ar^{c3} each independently represent a divalent aromatic hydrocarbon group, a divalent hetero ring group, or a divalent group in which two or more groups of divalent aromatic hydrocarbon groups and divalent hetero ring groups are connected directly or via a connecting group, and these groups optionally have a substituent, when a plurality of Ar^{a2} and Ar^{a3} are present, they may be the same or different at each occurrence,
R^{a1}, R^{a2}, R^{c1}, R^{c2}, R^{c3} and R^{c4} each independently represent an alkyl group, an aryl group or a monovalent hetero ring group, and these groups optionally have a substituent, when a plurality of R^{a1} and R^{a2} are present, they may be the same or different at each occurrence,
a1 represents 0, 1 or 2,
a2, c1, c2 and c3 each independently represent 0 or 1,
Z^{a1} and Z^{a2} each independently represent a chlorine atom, a bromine atom, an iodine atom, -O-S(=O)₂R^{Z}, - S(=O)₂Cl, -S(=O)₂R^{Z}, -N₂⁺BF₄⁻, -SR^{Z}, -NR^{Z}₃⁺OTf⁻, -OR^{Z}, -O-C(=O)R^{Z} or -C(=O)-OR^{Z}, R^{Z} represents an alkyl group, an aryl group or a monovalent hetero ring group, and these groups optionally have a substituent, when a plurality of R^{Z} are present, they may be the same or different.

6. The production method of a polymer compound according to claim 5, wherein said second step is any of said steps (A) to (D).

7. A method of producing a light emitting device having an anode, a cathode and an organic layer, comprising
a step of producing a polymer compound by the production method as described in claim 2, 3, 5 or 6, and
a step of forming between an anode and a cathode an organic layer using a composition containing (a) said polymer compound, (b) at least one compound selected from the group consisting of a light emitting compound, a charge transporting compound and a charge injection compound, different from said polymer compound, and (c) a solvent.
